# EUROPEAN PATENT APPLICATION

(11) **EP 4 694 612 A1**
(43) Date of publication of application: **11.02.2026**
(21) Application number: 25193857.7
(22) Date of filing: 04.08.2025
(51) Int. Cl.: H10B 12/00

(54) **SEMICONDUCTOR DEVICES INCLUDING A VERTICAL CHANNEL**

(30) Priority: 06.08.2024 KR 20240104807
(71) Applicant: Samsung Electronics Co., Ltd., Suwon-si, Gyeonggi-do 16677 (KR)
(72) Inventor: JANG, Seohyeong, 16677 Suwon-si (KR); KIM, Kyounghwan, 16677 Suwon-si (KR); KIM, Moonkeun, 16677 Suwon-si (KR); KIM, Suhyun, 16677 Suwon-si (KR); KIM, Yeonju, 16677 Suwon-si (KR); CHUNG, Kyungjae, 16677 Suwon-si (KR)
(74) Representative: Marks & Clerk LLP

(57) **Abstract**

A semiconductor device includes a bit line structure on a substrate and extending in a first direction parallel to an upper surface of the substrate, a channel on and electrically connected to the bit line structure, a front-gate electrode structure at a side of the channel in the first direction, the front-gate electrode structure including a first conductive pattern and a second conductive pattern, the second conductive pattern covering opposite sidewalls and an upper surface of the first conductive pattern, and a capacitor on and electrically connected to the channel.

## Description

### TECHNICAL FIELD

Example embodiments of the present disclosure relate to a semiconductor device. More particularly, example embodiments of the present disclosure relate to a memory device including a vertical channel.

### DISCUSSION OF RELATED ART

In order to improve an integration degree of a semiconductor device, a memory device including a vertical channel transistor has been developed. In a method of manufacturing the vertical channel memory device, the quality of a front-gate electrode may deteriorate due to heat accompanying the formation process of a landing pad structure. Accordingly, a heat treatment process of the formation process of a landing pad structure may be performed in a limited manner (or only in a limited manner).

### SUMMARY

Example embodiments provide a semiconductor device having improved characteristics.

Some example embodiments of inventive concepts provide a semiconductor device. The semiconductor device may include a bit line structure on a substrate and extending in a first direction parallel to an upper surface of the substrate, a channel on and electrically connected to the bit line structure, a front-gate electrode structure at a side of the channel in the first direction, the front-gate electrode structure including a first conductive pattern and a second conductive pattern, the second conductive pattern covering opposite sidewalls and an upper surface of the first conductive pattern, and a capacitor on and electrically connected to the channel.

Some example embodiments of inventive concepts provide a semiconductor device. The semiconductor device may include a bit line structure on a substrate and extending in a first direction parallel to an upper surface of the substrate, a channel on and electrically connected to the bit line structure, a front-gate electrode structure and a front-gate insulation pattern, the front-gate electrode structure and the front-gate insulation pattern sequentially stacked at a side of the channel in the first direction, a capacitor on and electrically connected to the channel, and wherein the front-gate electrode structure includes a first conductive pattern and a second conductive pattern sequentially stacked on the bit line structure in a vertical direction perpendicular to the upper surface of the substrate, and wherein the front-gate insulation pattern contacts a sidewall of each of the first conductive pattern and the second conductive pattern in the first direction.

Some example embodiments of inventive concepts provide a semiconductor device. The semiconductor device may include a bit line structure on a substrate, and the bit line structure extending in a first direction parallel to an upper surface of the substrate, a channel on and electrically connected to the bit line structure, a front-gate electrode structure at a side of the channel in the first direction, the front-gate electrode structure including a first conductive pattern and a second conductive pattern sequentially stacked on the bit line structure in a vertical direction perpendicular to the upper surface of the substrate, a back-gate electrode structure at another side of the channel in the first direction, and a capacitor on and electrically connected to the channel, wherein a cross-section of each of the first conductive pattern and the second conductive pattern taken along a plane defined by the first direction and the vertical direction is symmetrical about a center line that extends in the vertical direction and passes through a geometric center of the front-gate electrode structure.

Some example embodiments of inventive concepts provide a method of manufacturing a semiconductor device in which a mold layer may be formed on the substrate to define a space in which the front-gate electrode is to be formed, the landing pad structure is formed on the mold layer, the substrate is turned and the mold layer is removed to form an opening, and the front-gate electrode is provided within the opening formed by removing the mold layer. Accordingly, the front-gate electrode may not be damaged due to heat accompanying the landing pad structure forming process, and therefore, heat treatment process of the landing pad structure forming process may not be limited.

At least some of the above and other features of the invention are set out in the claims.

### BRIEF DESCRIPTION OF THE DRAWINGS

FIGS. 1 and 2 are cross-sectional views illustrating a semiconductor device in accordance with some example embodiments.
FIGS. 3 to 26 are plan views and cross-sectional views illustrating a method of manufacturing a semiconductor device in accordance with some example embodiments.
FIG. 27 is a cross-sectional view illustrating a semiconductor device in accordance with some example embodiments.
FIG. 28 is a cross-sectional view illustrating a semiconductor device in accordance with some example embodiments.
FIG. 29 is a cross-sectional view illustrating a semiconductor device in accordance with some example embodiments.
FIGS. 30 to 33 are cross-sectional views illustrating a method of manufacturing a semiconductor device in accordance with some example embodiments.
FIG. 34 is a cross-sectional view illustrating a semiconductor device in accordance with some example embodiments.
FIG. 35 is a cross-sectional view illustrating a semiconductor device in accordance with some example embodiments.
FIG. 36 is a cross-sectional view illustrating a semiconductor device in accordance with some example embodiments.
FIGS. 37 to 40 are cross-sectional views illustrating a method of manufacturing a semiconductor device in accordance with some example embodiments.
FIG. 41 is a cross-sectional view illustrating a semiconductor device in accordance with some example embodiments.
FIG. 42 is a cross-sectional view illustrating a semiconductor device in accordance with some example embodiments.

### DETAILED DESCRIPTION

The above and other aspects and features of a semiconductor device and a method of forming the same in accordance with some example embodiments will become readily understood from detail descriptions that follow, with reference to the accompanying drawings. It will be understood that, although the terms "first," "second," and/or "third" may be used herein to describe various materials, layers (films), regions, electrodes, pads, patterns, structures and processes, these materials, layers (films), regions, electrodes, pads, patterns, structures and processes should not be limited by these terms. These terms are only used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

As described herein, an element that is "on" another element may be above or beneath or adjacent (e.g., horizontally adjacent) to the other element. An element that is on another element may be directly on the other element, such that the element is in direct contact with the other element. An element that is on another element may be indirectly on the other element, such that the element is isolated from direct contact with the other element by one or more interposing spaces and/or structures.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular" with regard to other elements and/or properties thereof will be understood to be "perpendicular" with regard to the other elements and/or properties thereof within manufacturing tolerances and/or material tolerances and/or have a deviation in magnitude and/or angle from "perpendicular," or the like with regard to the other elements and/or properties thereof that is equal to or less than 10% (e.g., a. tolerance of ±10%).

Elements and/or properties thereof (e.g., structures, surfaces, directions, or the like) that are "substantially parallel" with regard to other elements and/or properties thereof will be understood to be "parallel" with regard to the other elements and/or properties thereof within manufacturing tolerances and/or material tolerances and/or have a deviation in magnitude and/or angle from "parallel," or the like with regard to the other elements and/or properties thereof that is equal to or less than 10% (e.g., a. tolerance of ±10%).

Elements and/or properties thereof (e.g., structures, surfaces, directions, or the like) that are "substantially coplanar" with regard to other elements and/or properties thereof will be understood to be "coplanar" with regard to the other elements and/or properties thereof within manufacturing tolerances and/or material tolerances and/or have a deviation in magnitude and/or angle from "coplanar," or the like with regard to the other elements and/or properties thereof that is equal to or less than 10% (e.g., a. tolerance of ±10%).

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

It will be understood that elements and/or properties thereof may be recited herein as being "the same" as or "equal" to other elements, and it will be further understood that elements and/or properties thereof recited herein as being "the same" as, or "equal" to other elements may be "the same" as, or "equal" to or "substantially the same" as or "substantially equal" to the other elements and/or properties thereof. Elements and/or properties thereof that are "substantially the same" as or "substantially equal" to other elements and/or properties thereof will be understood to include elements and/or properties thereof that are the same as, or equal to the other elements and/or properties thereof within manufacturing tolerances and/or material tolerances. Elements and/or properties thereof that are the same or substantially the same as other elements and/or properties thereof may be structurally the same or substantially the same, functionally the same or substantially the same, and/or compositionally the same or substantially the same.

Hereinafter, in the specification (and not necessarily in the claims), two directions that are substantially perpendicular to each other among horizontal directions, which are substantially parallel to an upper surface of a substrate, may be referred to as the first direction D1 and the second direction D2, respectively, and a vertical direction substantially perpendicular to the upper surface of the substrate may be referred to as a third direction D3. In some example embodiments, the first and second directions D1 and D2 may be orthogonal to each other. In the following description, labels for a singular structure and/or element may be used to refer to a plurality (e.g., two or more) of the same structure and/or element. For example, "a channel 105" or "the channel 105" may refer to a single channel, and "a plurality of channels 105" or "the channels 105" may be used to refer to two or more of "the channels 105." For example, "a second trench 140" or "the second trench 140" may refer to a single trench, and "a plurality of trenches 140" may be used to refer to two or more of "the trenches 140." These examples are not an exhaustive list, and other examples may be found through the following description.

Each of the first to third directions D1, D2 and D3 may include not only a direction shown in the drawings but also a direction reverse thereto.

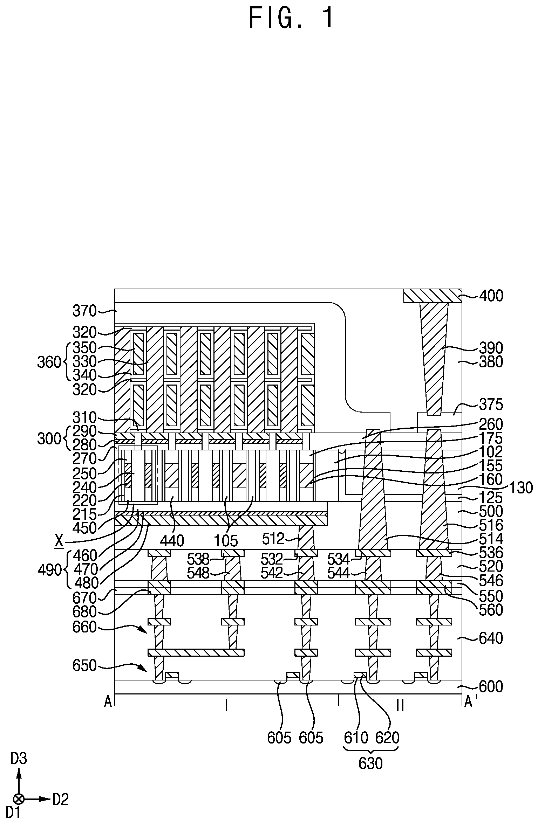

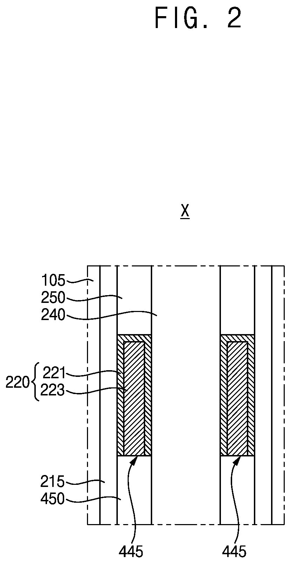

FIGS. 1 and 2 are cross-sectional views illustrating a semiconductor device in accordance with some example embodiments. FIG. 2 is an enlarged cross-sectional view of region X of FIG. 1.

Referring to FIGS. 1 and 2, the semiconductor device may include a peripheral circuit pattern 650 and memory cells that may be stacked in the third direction D3 on a second substrate 600.

For example, the semiconductor device may have a cell over periphery (COP) structure. However, inventive concepts are not limited thereto, and the semiconductor device may have a periphery over cell (POC) structure by, e.g., flipping the semiconductor device shown in FIG. 1.

The semiconductor device may include first and second gate structures, a channel 105, a bit line structure 490, a capacitor 360, a plate electrode 370, a first contact plug 270, a landing pad structure 300, the peripheral circuit pattern 650, and a wiring structure 660 on the second substrate 600.

The semiconductor device may further include a first etch stop pattern 125, a second insulation pattern 130, a third insulation pattern 240, a first capping pattern 175, a second capping pattern 250, a third capping pattern 440, a fourth capping pattern 450, a semiconductor pattern 102, a second contact plug 512, a first through via 390, a second through via 514, a third through via 516, a first via 542, a second via 544, a third via 546, a fourth via 548, a first wiring 532, a second wiring 534, a third wiring 536, a fourth wiring 538, a first insulating interlayer 260, a second insulating interlayer 380, a third insulating interlayer 500, a fourth insulating interlayer 520, a fifth insulating interlayer 640, a second etch stop layer 310, a support layer 320, a first conductive pad 375, a second conductive pad 400, a third bonding layer 550, a fourth bonding layer 670, a first bonding pattern 560, and a second bonding pattern 680.

The second substrate 600 may include a first region I and a second region II surrounding the first region I. The first region I may be a cell array region in which the memory cells are formed (or arranged), and the second region II may be an extension region in which through vias for transferring electrical signals to the memory cells are formed (or arranged).

The second substrate 600 may include a semiconductor material, e.g., silicon, germanium, silicon-germanium, or a III-V group compound semiconductor, e.g., GaP, GaAs, GaSb, etc., but example embodiments are not limited thereto.

The peripheral circuit pattern 650 may include, e.g., a transistor, and the transistor may include, e.g., a third gate structure 630 on the second substrate 600 and source/drain regions 605 at upper portions, respectively, of the second substrate 600 adjacent thereto. The third gate structure 630 may include a third gate insulation pattern 610 and a third gate electrode 620 sequentially stacked in the third direction D3.

The peripheral circuit pattern 650 may be circuit patterns for, e.g., a bit line sense amplifier (BLSA), a sub-word line driver (SWD), a column decoder, a column select line (CSL) driver, an input/output sense amplifier (I/O SA), a write driver, etc., but example embodiments are not limited thereto.

The wiring structure 660 may be disposed on the second substrate 600, and may be electrically connected to the peripheral circuit pattern 650. The wiring structure 660 may include, e.g., contact plugs, vias, wirings, etc., but example embodiments are not limited thereto.

The fifth insulating interlayer 640 may be disposed on the second substrate 600, and may cover the peripheral circuit pattern 650 and the wiring structure 660. The fifth insulating interlayer 640 may include, e.g., silicon oxide, silicon nitride, and/or a low-k dielectric material., but example embodiments are not limited thereto.

The fourth and third bonding layers 670 and 550 may be sequentially stacked on the fifth insulating interlayer 640 to form a bonding layer structure, and the second and first bonding patterns 680 and 560 may be disposed in the fourth and third bonding layers 670 and 550, respectively, to form a bonding pattern structure. The first and second bonding patterns 560 and 680 may include a metal, e.g., copper, and the third and fourth bonding layers 550 and 670 may include an insulating material, e.g., silicon carbonitride, silicon oxide, etc., but example embodiments are not limited thereto.

The first to fourth vias 542, 544, 546 and 548 may each contact upper surfaces of corresponding ones of the first bonding patterns 560, respectively, and the first to fourth wirings 532, 534, 536 and 538 may each contact upper surfaces of the first to fourth vias 542, 544, 546 and 548, respectively. The fourth insulating interlayer 520 may be disposed on the third bonding layer 550, and may cover sidewalls of the first to fourth vias 542, 544, 546, and 548 and the first to fourth wirings 532, 534, 536, and 538. The fourth insulating interlayer 520 may include, e.g., silicon oxide, silicon nitride, and/or a low-k dielectric material, but example embodiments are not limited thereto.

In some example embodiments, each of the first to fourth vias 542, 544, 546 and 548 may have a width gradually decreasing from a bottom toward a top thereof in the third direction D3, but example embodiments are not limited thereto.

The second contact plug 512 may contact an upper surface of the first wiring 532.

The bit line structure 490 may extend in the second direction D2 on the first region I of the second substrate 600, and a plurality of bit line structures 490 may be spaced apart from each other in the first direction D1. The bit line structure 490 may contact an upper surface of the second contact plug 512.

In some example embodiments, the bit line structure 490 may include a seventh conductive pattern 480, a sixth conductive pattern 470, and a fifth conductive pattern 460 sequentially stacked in the third direction D3. The fifth conductive pattern 460 may include, e.g., doped polysilicon, the sixth conductive pattern 470 may include a metal silicide, e.g., titanium silicide, tungsten silicide, etc., and the seventh conductive pattern 480 may include a metal, e.g., tungsten, titanium, etc., or a metal nitride, e.g., titanium nitride, but example embodiments are not limited thereto.

The third insulating interlayer 500 may be disposed on the fourth insulating interlayer 520, and may cover sidewalls of the second contact plug 512 and the bit line structure 490. The third insulating interlayer 500 may include, e.g., silicon oxide, silicon nitride, and/or a low-k dielectric material, but example embodiments are not limited thereto.

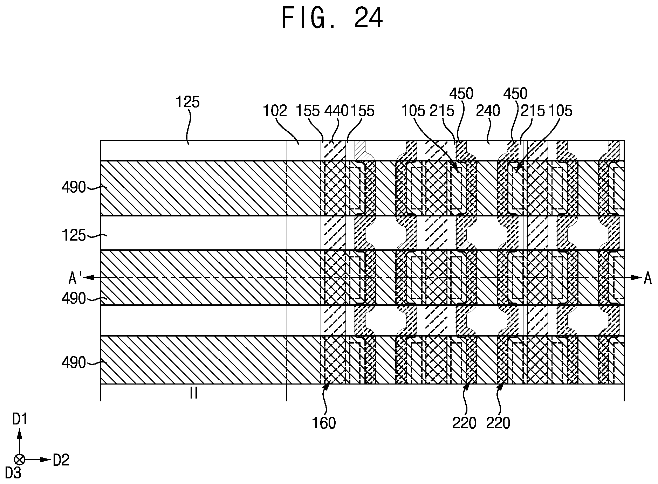

Referring to FIG. 1 together with FIG. 24, a plurality of channels 105 may be spaced apart from each other in the second direction D2 on each of the bit line structures 490 extending in the second direction D2, and thus the plurality of channels 105 may be spaced apart from each other in each of the first and second directions D1 and D2. Each of the channels 105 may extend to a given length in the third direction D3.

The channel 105 may include a semiconductor material, e.g., silicon, germanium, silicon-germanium, etc., but example embodiments are not limited thereto.

The first gate structure may be disposed on the first region I of the second substrate 600, and may contact upper surfaces of the bit line structure 490 and the third insulating interlayer 500. The first gate structure may include a back-gate electrode structure such as a first gate electrode structure 160 extending in the first direction D1, and a first gate insulation pattern 155 extending in the first direction D1 at each of opposite sidewalls in the second direction D2 of the first gate electrode structure 160. The first gate insulation pattern 155 may contact a sidewall of the channel 105 in the second direction D2.

In some example embodiments, the first gate electrode structure 160 may serve as a back-gate of the semiconductor device.

The first gate electrode structure 160 may include a conductive material, e.g., a metal, a metal nitride, a metal silicide, etc., and the first gate insulation pattern 155 may include an oxide, e.g., silicon oxide, but example embodiments are not limited thereto.

The first and third capping patterns 175 and 440 may be on and beneath, respectively, the first gate electrode structure 160, and a lower surface of the third capping pattern 440 may contact the upper surface of the bit line structure 490. The first gate insulation pattern 155 may contact each of opposite sidewalls in the second direction D2 of each of the first and third capping patterns 175 and 440.

In some example embodiments, an upper surface of the first capping pattern 175 may be substantially coplanar with upper surfaces of the first gate insulation pattern 155 and the channel 105, and a lower surface of the third capping pattern 440 may be substantially coplanar with lower surfaces of the first gate insulation pattern 155 and the channel 105.

Each of the first and third capping patterns 175 and 440 may include an insulating nitride, e.g., silicon nitride., but example embodiments are not limited thereto.

The second gate structure may be disposed on the first region I of the second substrate 600, and may contact the upper surfaces of the bit line structure 490 and the third insulating interlayer 500. The second gate structure may include a front-gate electrode structure such as a second gate electrode structure 220 extending in the first direction D1, and a second gate insulation pattern 215 extending in the first direction D1 on each of opposite sidewalls in the second direction D2 of the second gate electrode structure 220. The second gate insulation pattern 215 may contact another sidewall in the second direction D2 and each of opposite sidewalls in the first direction D1 of the channel 105 and a portion of a sidewall of the first gate insulation pattern 155.

In some example embodiments, each of the second gate electrode structure 220 and the second gate insulation pattern 215 may extend in the first direction D1, however, a sidewall of each of the second gate electrode structure 220 and the second gate insulation pattern 215 may not be in a straight line but have a winding shape in a plan view. In some example embodiments, the second gate electrode structure 220 may serve as a word line of the semiconductor device.

The second gate electrode structure 220 may include a fourth conductive pattern 223 and a third conductive pattern 221 covering opposite sidewalls and an upper surface of the fourth conductive pattern 223.

A cross-section of each of the third and fourth conductive patterns 221 and 223 taken along a plane defined by the second and third directions D2 and D3 may be substantially symmetrical about a center line that passes through a geometric center of the second gate electrode structure 220 and extends in the third direction D3.

The fourth conductive pattern 223 may include a metal, e.g., tungsten, molybdenum, ruthenium, cobalt, titanium, tantalum, etc., or a metal silicide, e.g., titanium silicide, tungsten silicide, etc., but example embodiments are not limited thereto. The third conductive pattern 221 may include a metal nitride, e.g., titanium nitride, tantalum nitride, tungsten nitride, molybdenum nitride, etc., and the second gate insulation pattern 215 may include an oxide, e.g., silicon oxide, but example embodiments are not limited thereto.

The second and fourth capping patterns 250 and 450 may be on and beneath, respectively, the second gate electrode structure 220, and a lower surface of the fourth capping pattern 450 may contact the upper surface of the bit line structure 490. The second gate insulation pattern 215 may contact each of opposite sidewalls in the second direction D2 of each of the second and fourth capping patterns 250 and 450.

In some example embodiments, an upper surface of the second capping pattern 250 may be substantially coplanar with upper surfaces of the second gate insulation pattern 215 and the channel 105, and a lower surface of the fourth capping pattern 450 may be substantially coplanar with lower surfaces of the second gate insulation pattern 215 and the channel 105.

Each of the second and fourth capping patterns 250 and 450 may include an insulating nitride, e.g., silicon nitride, but example embodiments are not limited thereto.

The third insulation pattern 240 may be disposed on the first region I of the second substrate 600, and may contact the upper surfaces of the bit line structure 490 and the third insulating interlayer 500. The third insulation pattern 240 may extend in the first direction D1, and may contact a sidewall of each of the second gate electrode structure 220 and the second and fourth capping patterns 250 and 450.

In some example embodiments, each of opposite sidewalls in the second direction D2 of the third insulation pattern 240 may have a winding shape in the first direction D1 in a plan view. For example, a width in the second direction D2 of the third insulation pattern 240 may periodically vary in the first direction D1, but example embodiments are not limited thereto.

In some example embodiments, an upper surface of the third insulation pattern 240 may be substantially coplanar with an upper surface of the second capping pattern 250.

The third insulation pattern 240 may include an oxide, e.g., silicon oxide, but example embodiments are not limited thereto.

Two of the second gate structures respectively formed on opposite sidewalls in the second direction D2 of the third insulation pattern 240 may together form a second gate structure pair. A plurality of second gate structure pairs and the first gate structures may be arranged alternately and repeatedly in the second direction D2, and the channel 105 may be disposed between the second gate structure pair and the first gate structure that are adjacent to each other in the second direction D2.

The semiconductor pattern 102 may be disposed on a portion of the first region I of the second substrate 600 adjacent to the second region II thereof, and may contact the upper surfaces of the bit line structure 490 and the third insulating interlayer 500. The semiconductor pattern 102 may extend in the first direction D1, and may contact a sidewall in the second direction D2 of the first gate insulation pattern 155.

In some example embodiments, the semiconductor pattern 102 may include a material substantially the same as that of the channel 105, e.g., a semiconductor material such as silicon, germanium, silicon-germanium, etc., but example embodiments are not limited thereto.

The first etch stop pattern 125 may be disposed on the second region II of the second substrate 600, and may contact the upper surface of the third insulating interlayer 500. In some example embodiments, a lower surface of the first etch stop pattern 125 may be substantially coplanar with lower surfaces of the semiconductor pattern 102, the channel 105, the third and fourth capping patterns 440 and 450, and the first and second gate insulation patterns 155 and 215.

In some example embodiments, the first etch stop pattern 125 may include a first portion contacting the upper surface of the third insulating interlayer 500 and having a flat plate shape extending in the horizontal direction, and a second portion having a flat plate shape extending from the first portion in the third direction D3 and contacting a sidewall of the semiconductor pattern 102 in the second direction D2. Thus, a cross-section of the first etch stop pattern 125 taken along a plane defined by the second and third directions D2 and D3 may have an "L" shape.

In some example embodiments, an upper surface of the second portion of the first etch stop pattern 125 may be concave upwardly. Thus, an edge portion of the upper surface of the second portion of the first etch stop pattern 125 may be substantially coplanar with upper surfaces of the semiconductor pattern 102 and the second insulation pattern 130, while a central portion of the upper surface of the second portion of first etch stop pattern 125 may be lower than the upper surfaces of the semiconductor pattern 102 and the second insulation pattern 130, but example embodiments are not limited thereto.

In some example embodiments, the upper surface of the second portion of the first etch stop pattern 125 may be substantially flat, and thus an entire portion of the upper surface of the second portion of first etch stop pattern 125 may be substantially coplanar with the upper surfaces of the semiconductor pattern 102 and the second insulation pattern 130.

The first etch stop pattern 125 may include an insulating nitride, e.g., silicon nitride, but example embodiments are not limited thereto.

The second insulation pattern 130 may be disposed on the first etch stop pattern 125 on the second region II of the second substrate 600. The second insulation pattern 130 may include an oxide, e.g., silicon oxide, but example embodiments are not limited thereto.

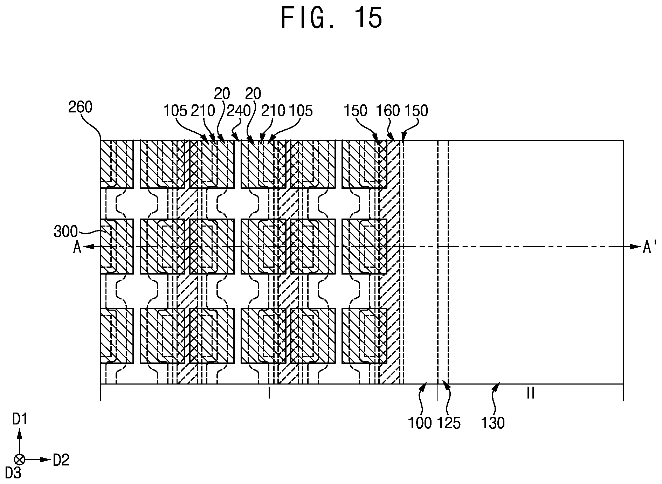

Referring to FIG. 1 together with FIG. 15, the first contact plug 270 may contact an upper surface of each of the channels 105, and the landing pad structure 300 may contact an upper surface of the first contact plug 270. Thus, a plurality of first contact plugs 270 may be spaced apart from each other in each of the first and second directions D1 and D2, and a plurality of landing pad structures 300 may be spaced apart from each other in each of the first and second directions D1 and D2, which may be arranged in a lattice pattern or a honeycomb pattern in a plan view.

The first contact plug 270 may contact upper surfaces of portions of the first and second gate insulation patterns 155 and 215 and the second capping pattern 250 adjacent to each of the channels 105 in the second direction D2, and upper surfaces of portions of the third insulation pattern 240 and the first capping pattern 175 adjacent to each of the channels 105 in the second direction D2.

The landing pad structure 300 may include a first conductive pattern 280 and a second conductive pattern 290 sequentially stacked in the third direction D3.

The first contact plug 270 may include, e.g., doped polysilicon, the first conductive pattern 280 may include a metal silicide, e.g., titanium silicide, tungsten silicide, etc., and the second conductive pattern 290 may include a metal, e.g., tungsten, titanium, etc., or a metal nitride, e.g., titanium nitride, but example embodiments are not limited thereto.

The first insulating interlayer 260 may be disposed on the second insulation pattern 130, the first etch stop pattern 125, the semiconductor pattern 102, the channel 105, the first and second gate insulation patterns 155 and 215, the first and second capping patterns 175 and 250, and the third insulation pattern 240, and may cover sidewalls of the first contact plug 270 and the landing pad structure 300. The first insulating interlayer 260 may include, e.g., silicon oxide, silicon nitride, a low-k dielectric material, but example embodiments are not limited thereto.

The second etch stop layer 310 may be disposed on the first region I of the second substrate 600, and may contact upper surfaces of the landing pad structure 300 and the first insulating interlayer 260. The second etch stop layer 310 may include an insulating nitride, e.g., silicon boronitride, but example embodiments are not limited thereto.

The capacitor 360 may include a first capacitor electrode 330, a dielectric layer 340, and a second capacitor electrode 350.

The first capacitor electrode 330 may contact the upper surface of each of the landing pad structures 300, and may extend in the third direction D3 to a given (or desired) length. Thus, a plurality of first capacitor electrodes 330 may be spaced apart from each other in each of the first and second directions D1 and D2. In some example embodiments, the first capacitor electrodes 330 may be arranged in a lattice pattern or a honeycomb pattern in a plan view.

Each of the first capacitor electrodes 330 may extend through the second etch stop layer 310, and the support layer 320 may be disposed on a sidewall of the first capacitor electrode 330. In some example embodiments, a plurality of support layers 320 may be spaced apart from each other in the third direction D3 on the sidewall of each of the first capacitor electrodes 330.

The dielectric layer 340 may be disposed on a sidewall of the first capacitor electrode 330, lower and upper surfaces and a sidewall of the support layer 320, and an upper surface and a sidewall of the second etch stop layer 310. The second capacitor electrode 350 may be disposed between neighboring support layers 320 in the third direction D3 and between a lowermost one of the support layers 320 and the second etch stop layer 310, and lower and upper surfaces and a sidewall of the second capacitor electrode 350 may be covered by the dielectric layer 340.

The plate electrode 370 may surround upper surfaces and sidewalls of the capacitor 360, the support layer 320, and the second etch stop layer 310.

Each of the first and second capacitor electrodes 330 and 350 may include, e.g., a metal, a metal nitride, a metal silicide, etc., and the dielectric layer 340 may include, e.g., a metal oxide, but example embodiments are not limited thereto. The support layer 320 may include an insulating nitride, e.g., silicon nitride, but example embodiments are not limited thereto. The plate electrode 370 may include, e.g., doped silicon-germanium, or a metal such as tungsten, but example embodiments are not limited thereto.

The first conductive pad 375 may contact the upper surface of the first insulating interlayer 260 on the second region II of the second substrate 600. In some example embodiments, the first conductive pad 375 may include substantially the same material as the plate electrode 370, however, inventive concepts are not limited thereto.

The second and third through vias 514 and 516 may extend through the third insulating interlayer 500, the first etch stop pattern 125, the second insulation pattern 130, and the first insulating interlayer 260, and may contact respective lower surfaces of the plate electrode 370 and the first conductive pad 375. In some example embodiments, each of the second and third through vias 514 and 516 may have a horizontal width gradually decreasing from a bottom toward a top thereof in the third direction D3, but example embodiments are not limited thereto.

The first through via 390 may contact an upper surface of the first conductive pad 375, and may extend in the third direction D3. In some example embodiments, the first through via 390 may have a horizontal width gradually increasing from a bottom toward a top thereof in the third direction D3, but example embodiments are not limited thereto.

The second conductive pad 400 may contact an upper surface of the first through via 390. The second conductive pad 400 may be electrically connected to an upper wiring that may apply input/output signals.

Each of the first to third through vias 390, 514 and 516, and the second conductive pad 400 may include a conductive material, e.g., a metal, a metal nitride, a metal silicide, etc., but example embodiments are not limited thereto.

The second insulating interlayer 380 may be disposed on the first insulating interlayer 260 and the landing pad structure 300, and may cover upper surfaces and sidewalls of the plate electrode 370 and the first conductive pad 375, and sidewalls of the first through via 390 and the second conductive pad 400. The second insulating interlayer 380 may include, e.g., silicon oxide, silicon nitride, a low-k dielectric material, but example embodiments are not limited thereto.

In the semiconductor device, the fifth conductive pattern 460 of the bit line structure 490 and the first contact plug 270 may serve as source/drain layers, respectively, and current may flow in the third direction D3 in the channel 105 between the source/drain layers. Thus, the semiconductor device may include a vertical channel transistor (VCT) having a vertical channel.

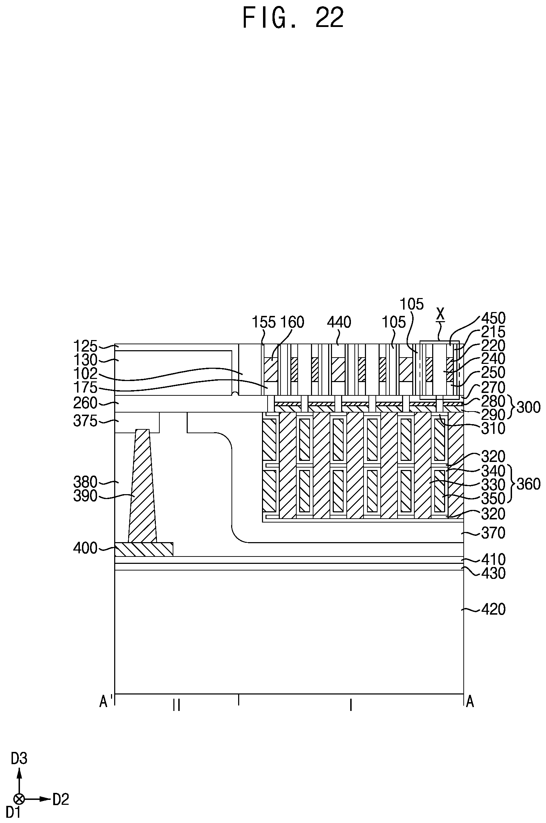

FIGS. 2 to 26 are plan views and cross-sectional views illustrating a method of manufacturing a semiconductor device in accordance with some example embodiments.

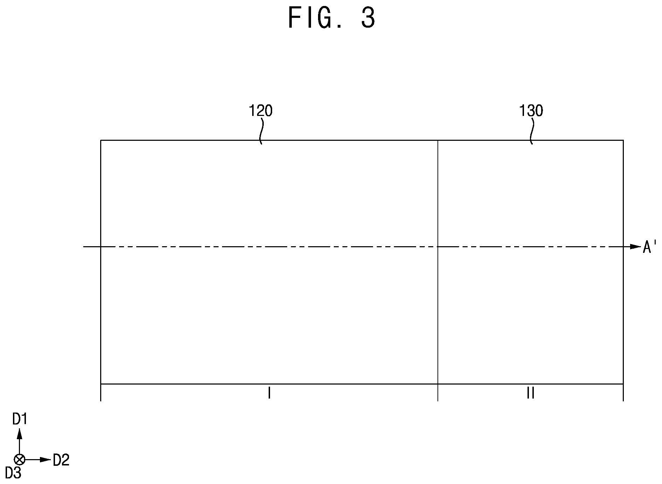

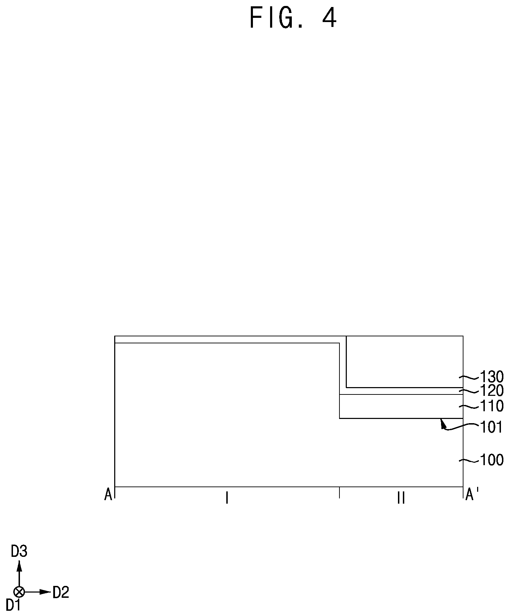

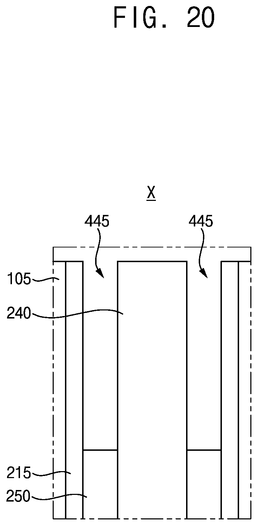

Specifically, FIGS. 3, 6, 8, 11, 13, 15, 21 and 24 are plan views, and FIGS. 4, 5, 7, 9-10, 12, 14, 16-20, 22-23 and 25-26 are cross-sectional views taken along lines A-A' of corresponding plan views, respectively. FIGS. 20, 23 and 27 are enlarged cross-sectional views of region X of corresponding cross-sectional views.

Referring to FIGS. 3 and 4, an upper portion of a second region II of a first substrate 100, including a first region I and the second region II, may be removed to form a first trench 101, a first insulation pattern 110 may be formed in a lower portion of the first trench 101, a first etch stop layer 120 may be formed on an upper surface and a sidewall of the first substrate 100 and an upper surface of the first insulation pattern 110, and a second insulation pattern 130 may be formed on the first etch stop layer 120.

The first substrate 100 may include silicon, germanium, silicon-germanium, or a III-V group compound semiconductor, such as GaP, GaAs, or GaSb, but example embodiments are not limited thereto. In some example embodiments, the first substrate 100 may be a silicon-on-insulator (SOI) substrate or a germanium-on-insulator (GOI) substrate, but example embodiments are not limited thereto.

The first insulation pattern 110 may be formed by forming a first insulation layer on the first and second regions I and II of the first substrate 100 having the first trench 101 thereon, and performing an etch back process on the first insulation layer to remove an upper portion of the first insulation layer. The first insulation pattern 110 may include an oxide, e.g., silicon oxide, and the first etch stop layer 120 may include an insulating nitride, e.g., silicon nitride, but example embodiments are not limited thereto.

The second insulation pattern 130 may be formed by forming a second insulation layer on the first etch stop layer 120, and performing a planarization process, e.g., a chemical mechanical polishing (CMP) process on the second insulation layer until an upper surface of a portion of the first etch stop layer 120 on the first region I of the first substrate 100 is exposed. Thus, an upper surface of the second insulation pattern 130 may be substantially coplanar with the upper surface of the portion of the first etch stop layer 120 on the first region I of the first substrate 100.

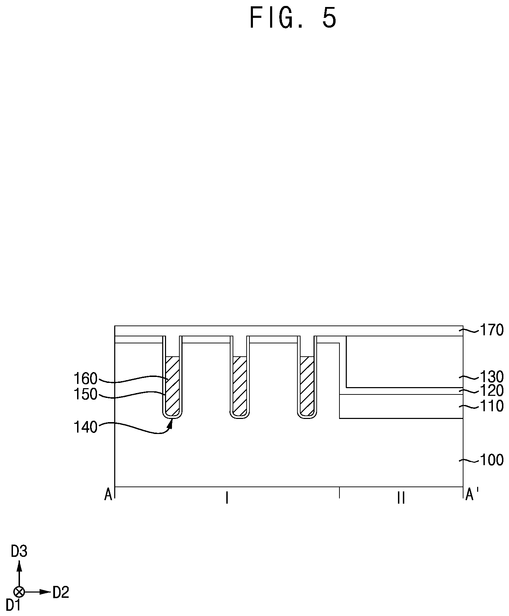

Referring to FIG. 5, the upper portion of the first etch stop layer 120 and an upper portion of the first region I of the first substrate 100 thereunder may be partially removed to form a second trench 140, a first gate insulation layer 150 may be formed on an inner wall of the second trench 140, an upper surface of the first etch stop layer 120 and an upper surface of the second insulation pattern 130, a first gate electrode layer may be formed on the first gate insulation layer 150 to fill the second trench 140, and a planarization process, e.g., a CMP process may be performed on the first gate electrode layer and the first gate insulation layer until the upper surfaces of the first etch stop layer 120 and the second insulation pattern 130 are exposed.

Thus, the first gate insulation layer 150 may remain on the inner wall of the second trench 140, and a first gate electrode structure 160 may be formed in the second trench 140. In some example embodiments, the second trench 140 may extend in the first direction D1 on the first region I of the first substrate 100, and a plurality of second trenches 140 may be spaced apart from each other in the second direction D2. A cross-section of the first gate insulation layer 150 taken along a plane defined by the second and third directions D2 and D3 may have a "U" shape.

An upper portion of the first gate electrode structure 160 may be removed by, e.g., an etch back process to form a first recess, and a first capping layer 170 may be formed on the first gate electrode structure 160, the first gate insulation layer 150, the first etch stop layer 120, and the second insulation pattern 130 to fill the first recess.

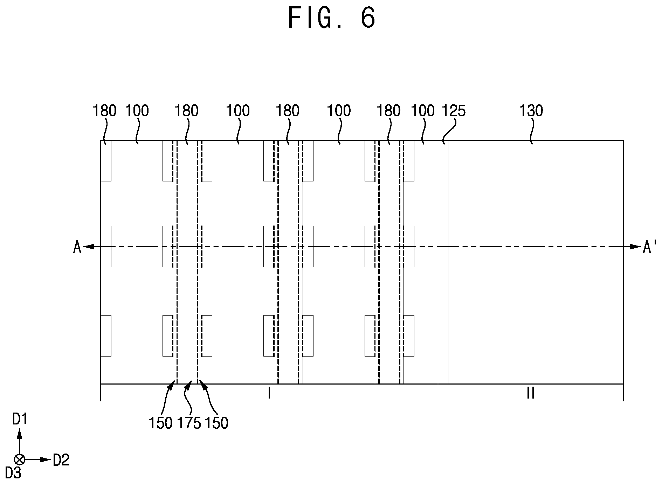

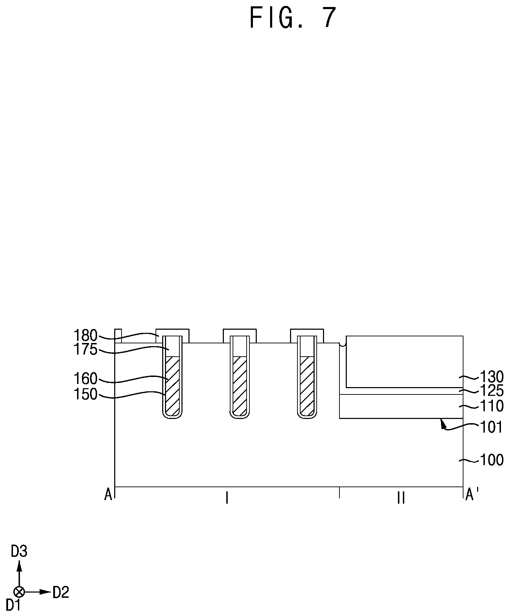

Referring to FIGS. 6 and 7, an upper portion of the first capping layer 170 may be removed by, e.g., a CMP process and/or an etch back process to expose the upper surface of the first etch stop layer 120, an uppermost surface of the first gate insulation layer 150 and the upper surface of the second insulation pattern 130, and a first capping pattern 175 may be formed in the first recess.

For example, a wet etching process may be performed to remove a portion of first etch stop layer 120 on the first region I of the first substrate 100 and a portion of the first etch stop layer 120 on a portion of the second region II of the first substrate 100 adjacent to the first region I thereof, and thus a first etch stop pattern 125 may remain on the second region II of the first substrate 100. By the wet etching process, an upper surface of the first region I of the first substrate 100 and an upper sidewall of the first gate insulation layer 150 may be exposed.

In some example embodiments, an uppermost surface of a portion of the first etch stop pattern 125 on the portion of the second region II of the first substrate 100, adjacent to the first region I thereof, may be concave upwardly due to the characteristic of the wet etching process.

A spacer layer may be formed on the first substrate 100, the first gate insulation layer 150, the first capping pattern 175, the first etch stop pattern 125, and the second insulation pattern 130, and may be partially etched to form a preliminary spacer 180. In some example embodiments, the preliminary spacer 180 may cover an upper surface of the first capping pattern 175 and an uppermost surface of the first gate insulation layer 150, and may also cover an upper sidewall of a portion of the first gate insulation layer 150 and an upper surface of a portion of the first substrate 100 adjacent to the portion of the first gate insulation layer 150.

In some example embodiments, the preliminary spacer 180 may extend in the first direction D1 on the first region I of the first substrate 100, and a plurality of preliminary spacers 180 may be spaced apart from each other in the second direction D2. Each of opposite sidewalls in the second direction D2 of the preliminary spacer 180 may not be formed in a straight line but may have a zigzag pattern in the first direction D1, but example embodiments are not limited thereto.

The preliminary spacer 180 may include an oxide, e.g., silicon oxide, but example embodiments are not limited thereto.

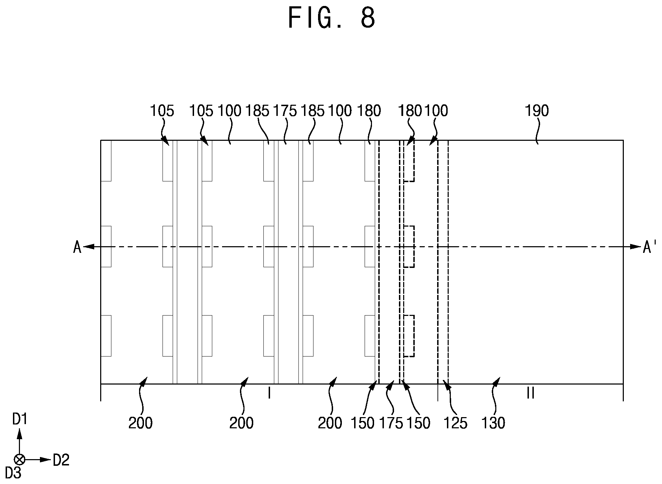

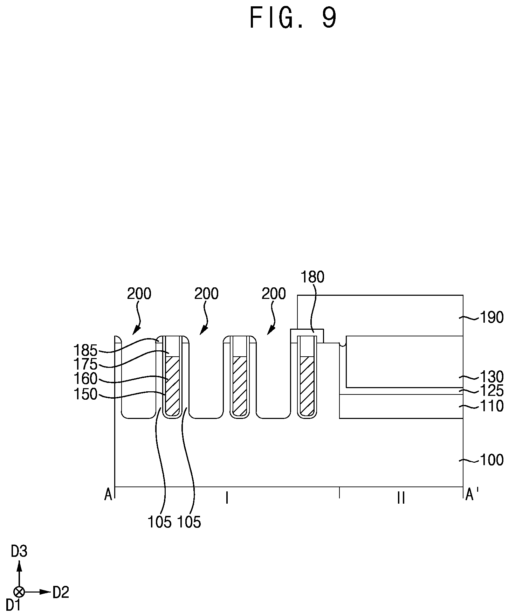

Referring to FIGS. 8 and 9, a mask 190 covering the second region II of the first substrate 100, a portion of the first region I of the first substrate 100 adjacent to the second region II thereof, and the first capping pattern 175, the first gate insulation layer 150, and the preliminary spacer 180 adjacent thereto, may be formed.

The mask 190 may include, e.g., a photoresist layer, but example embodiments are not limited thereto.

An anisotropic etching process may be performed on the preliminary spacers 180 on other portions of the first region I of the first substrate 100 to form a spacer 185 on the upper sidewall of the first gate insulation layer 150, and an etching process may be performed using the spacer 185, the first capping pattern 175, the first gate insulation layer 150, and the mask 190 as an etching mask to partially remove the upper portion of the first substrate 100 so that a third trench 200 may be formed.

In some example embodiments, the third trench 200 may extend in the first direction D1, and a plurality of third trenches 200 may be spaced apart from each other in the second direction D2. Each of opposite sidewalls in the second direction D2 of the third trench 200 may not be formed in a straight line but may have a zigzag pattern in the first direction D1, but example embodiments are not limited thereto.

For example, a width in the second direction D2 of the third trench 200 may not be uniform in the first direction D1, and may periodically vary in the first direction D1. Each of opposite sidewalls in the second direction D2 of a portion of the third trench 200 having a relatively large width (or a large width) in the second direction D2 may expose a sidewall of the first gate insulation layer 150. A channel 105 may be formed between each of opposite sidewalls in the second direction D2 of a portion of the third trench 200 having a relatively small width (or a small width) in the second direction D2 and the first gate insulation layer 150.

In some example embodiments, a plurality of channels 105 may be spaced apart from each other in the first direction D1 on a sidewall of the first gate insulation layer 150.

In some example embodiments, a bottom of the third trench 200 may be substantially coplanar with a lower surface of the first gate insulation layer 150, however, inventive concepts are not limited thereto.

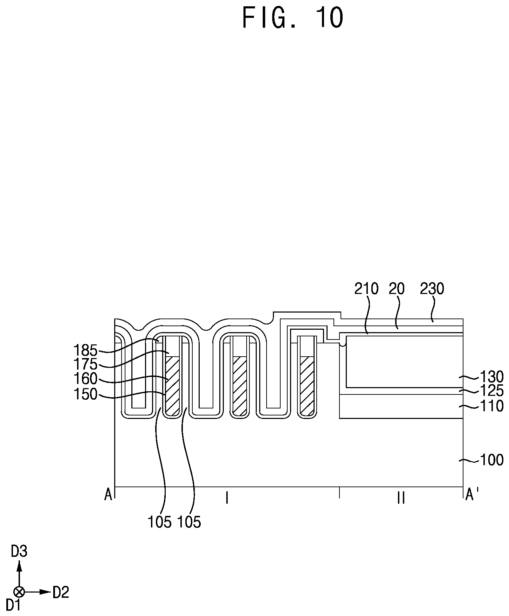

Referring to FIG. 10, the mask 190 may be removed by, e.g., an ashing process and/or a stripping process, and a second gate insulation layer 210 and a second mold layer 20 may be sequentially stacked on an inner wall of the third trench 200, a surface of the spacer 185, the uppermost surface of the first gate insulation layer 150, the upper surface of the first capping pattern 175, an upper surface and a sidewall of the preliminary spacer 180, the upper surface of the portion of the first region I of the first substrate 100 adjacent to the second region II thereof, the uppermost surface of the first etch stop pattern 125, and the upper surface of the second insulation pattern 130. The second mold layer 20 may include nitride, e.g., silicon nitride, but example embodiments are not limited thereto.

A third insulation layer 230 may be formed on the second mold layer 20 to fill the third trench 200. The third insulation layer 230 may include an oxide, e.g., silicon oxide, but example embodiments are not limited thereto.

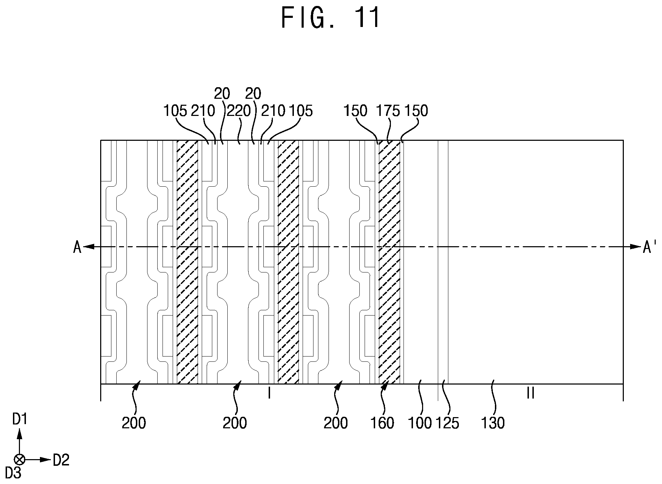

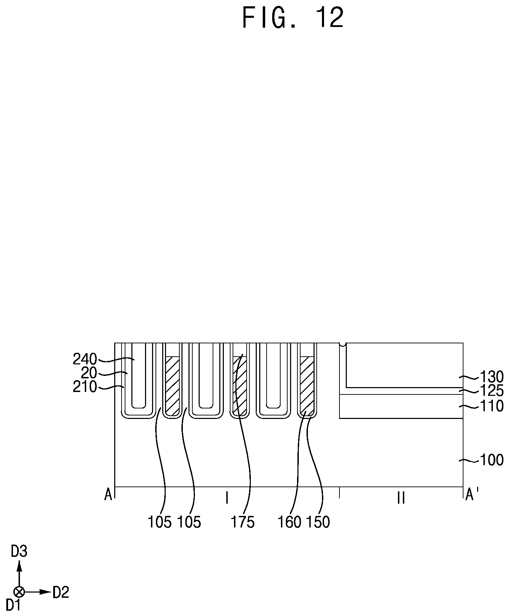

Referring to FIGS. 11 and 12, a planarization process, e.g., a CMP process may be performed on the third insulation layer 230, the second mold layer 20, and the second gate insulation layer 210 until the upper surface of the first substrate 100 is exposed.

Thus, the second gate insulation layer 210 and the second mold layer 20 may remain on the inner wall of the third trench 200, and a third insulation pattern 240 may be formed in the third trench 200. A cross-section of each of the second gate insulation layer 210 and the second mold layer 20 taken along a plane defined by the second and third directions D2 and D3 may have a "U" shape.

During the planarization process, the spacer 185 and the preliminary spacer 180 may be removed, and upper portions of the first capping pattern 175, the first gate insulation layer 150, and the second insulation pattern 130 may also be removed.

In some example embodiments, the uppermost surface of the first etch stop pattern 125 may be concave even after the planarization process, which is shown in FIG. 12, but example embodiments are not limited thereto. In some example embodiments, the uppermost surface of the first etch stop pattern 125 may be planarized during the planarization process so as to be substantially flat and coplanar with the upper surfaces of the first substrate 100 and the second insulation pattern 130.

In some example embodiments, the second gate insulation layer 210 may extend in the first direction D1, and may cover a sidewall in the second direction D2 of the first gate insulation layer 150, and opposite sidewalls in the first direction D1 of the channel 105. Additionally or alternatively, the second mold layer 20 may extend in the first direction D1, and may cover a sidewall of the first gate insulation layer 150. In some example embodiments, each of the second gate insulation layer 210 and the second mold 20 may not be formed in a straight line in the first direction D1 but may have a zigzag shape, but example embodiments are not limited thereto.

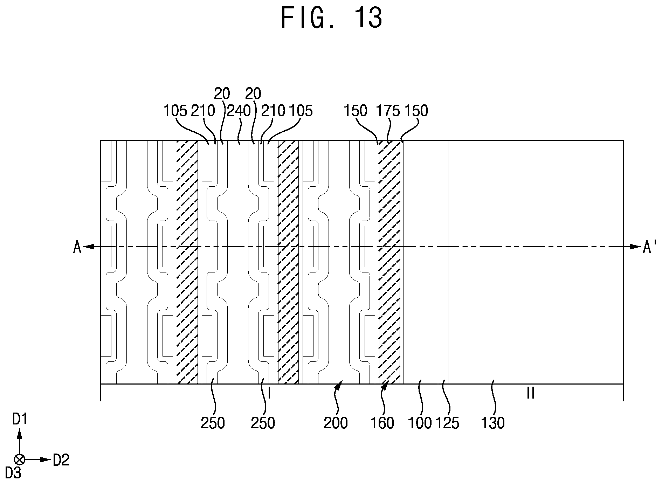

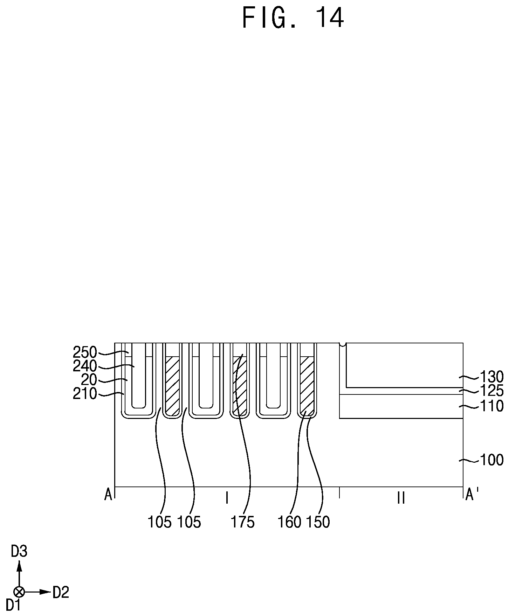

Referring to FIGS. 13 and 14, an upper portion of the second mold layer 20 may be removed to form a second recess, and a second capping pattern 250 may be formed in the second recess.

The second capping pattern 250 may include an oxide, e.g., silicon oxide, but example embodiments are not limited thereto. When the third insulation pattern 240 and the second capping pattern 250 are formed to include a substantially same material, the third insulation pattern 240 and the second capping pattern 250 may be merged.

In some example embodiments, a lower surface of the second capping pattern 250 may be substantially coplanar with the lower surface of the first capping pattern 175, however, inventive concepts are not limited thereto.

Meanwhile, in some example embodiments, the second capping pattern 250 may not be formed.

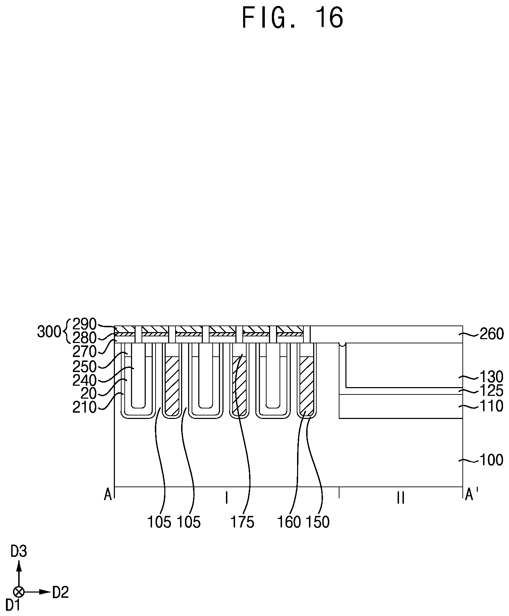

Referring to FIGS. 15 and 16, a contact plug layer and a landing pad structure layer may be sequentially formed on the first and second capping patterns 175 and 250, the first and second gate insulation layers 150 and 210, the third insulation pattern 240, the channel 105, the first etch stop pattern 125, and the second insulation pattern 130, the contact plug layer and the landing pad structure layer may be patterned to form a first contact plug 270 and a landing pad structure 300, respectively, which may contact an upper surface of the channel 105 and an upper surface of the first contact plug 270, respectively, and a first insulating interlayer 260 may be formed to cover sidewalls of the first contact plug 270 and the landing pad structure 300.

The first contact plug 270 may contact not only the upper surface of the channel 105 but also upper surfaces of the first and second gate insulation layers 150 and 210, and the second capping pattern 250 at opposite sides of the channel 105 in the second direction D2, and upper surfaces of portions of the first capping pattern 175 and the third insulation pattern 240.

The landing pad structure 300 may include first and second conductive patterns 280 and 290 stacked in the third direction D3.

In some example embodiments, a plurality of first contact plugs 270 may be spaced apart from each other in each of the first and second directions D1 and D2, and a plurality of landing pad structures 300 may be spaced apart from each other in each of the first and second directions D1 and D2 on the first region I of the first substrate 100. The first contact plugs 270 and the landing pad structures 300 may be arranged in a lattice pattern or a honeycomb pattern in a plan view.

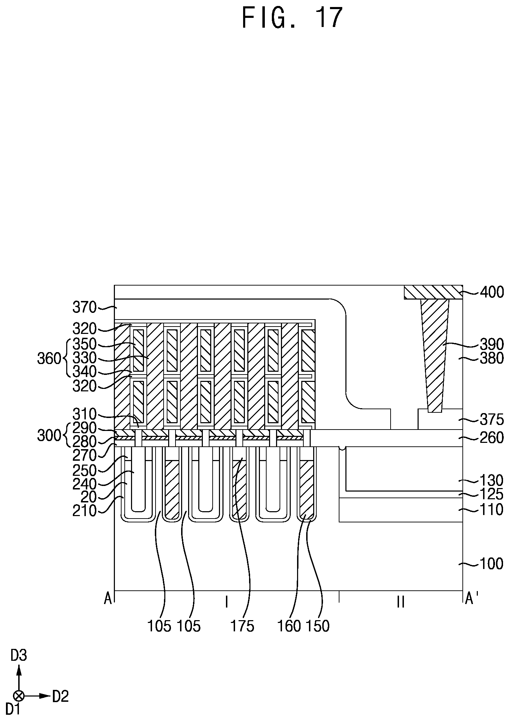

Referring to FIG. 17, a capacitor 360 and a plate electrode 370 may be formed on the first insulating interlayer 260 and the landing pad structure 300.

The capacitor 360 and the plate electrode 370 may be formed by following processes.

A second etch stop layer 310 may be formed on the first insulating interlayer 260 and the landing pad structure 300, and a mold layer and a support layer 320 may be alternately and repeatedly stacked on the second etch stop layer 310.

First openings, which may extend through the mold layer and the second etch stop layer 310 to expose upper surfaces of the landing pad structures 300, respectively, may be formed on the first region I of the first substrate 100, a first capacitor electrode layer may be formed on the upper surfaces of the landing pad structures 300 exposed by the first openings and an upper surface of an uppermost one of the support layers 320, and a planarization process may be performed on the first capacitor electrode layer until the upper surface of the uppermost one of the support layers 320 is exposed so that a first capacitor electrode 330 may be formed in each of the first openings.

The planarization process may include a CMP process and/or an etch back process, but example embodiments are not limited thereto.

Portions of the support layer 320 and the mold layer on the second region II of the first substrate 100 may be removed, portions of the support layer 320 and the mold layer on the first region I of the first substrate 100 may be partially removed to form a second opening, and the mold layer may be removed through the second opening.

In some example embodiments, the mold layer may be removed by, e.g., a wet etching process, and a third opening may be formed to expose a sidewall of the first capacitor electrode 330 and an upper surface of the second etch stop layer 310. However, the support layers 320 may remain on the sidewall of the first capacitor electrode 330, and thus surfaces of the support layers 320 may also be exposed by the third opening.

A dielectric layer 340 may be formed on sidewalls of the first capacitor electrodes 330, the upper surface of the second etch stop layer 310 and the surfaces of the support layers 320 exposed by the third opening, and a second capacitor electrode layer may be formed on the dielectric layer 340 to fill a remaining portion of the third opening. The dielectric layer 340 and the second capacitor electrode layer may also be stacked on the upper surface of the first capacitor electrode 330 and the upper surface of the uppermost one of the support layers 320.

For example, a wet etching process may be performed on the second capacitor electrode layer to form a second capacitor electrode 350 in the third opening. The first capacitor electrode 330, the dielectric layer 340, and the second capacitor electrode 350 may collectively form a capacitor 360.

A plate electrode 370 may be formed on an upper surface of the capacitor 360 and an upper surface of the first insulating interlayer 260. The plate electrode 370 may be formed on the first region I of the first substrate 100 and a portion of the second region II of the first substrate 100 adjacent thereto, and during the formation of the plate electrode 370, a first conductive pad 375 may be formed on the second region II of the first substrate 100.

A second insulating interlayer 380 may be formed on the first insulating interlayer 260 to cover the plate electrode 370 and the first conductive pad 375, and a first through via 390 and a second conductive pad 400 may be formed in the second insulating interlayer 380.

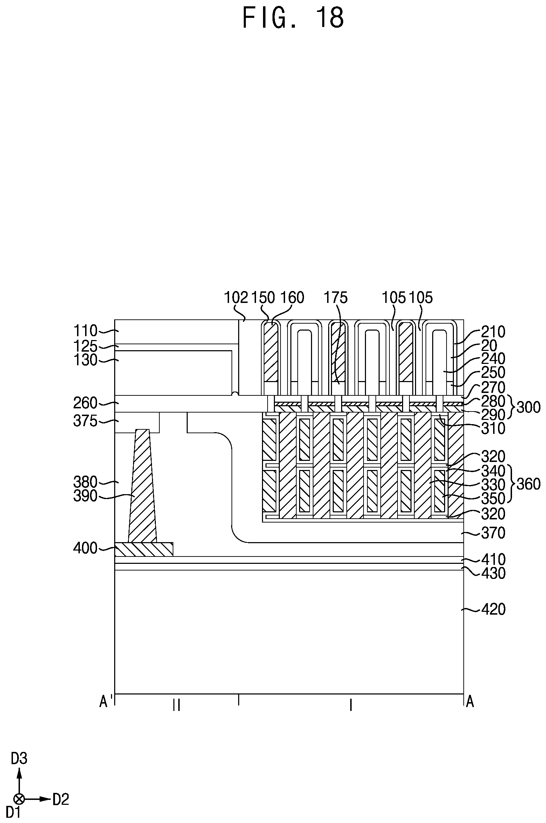

Referring to FIG. 18, a first bonding layer 410 may be formed on the second insulating interlayer 380 and the second conductive pad 400, a second bonding layer 430 may be formed on a handling substrate 420, the first substrate 100 may be flipped, and the first and second bonding layers 410 and 430 may be bonded with each other.

Thus, structures on the first substrate 100 may be inverted, flipping its top and bottom, and hereinafter, following explanations are based on this orientation. Additionally or alternatively, respective portions of the handling substrate 420 overlapping the first and second regions I and II of the first substrate 100 may be referred to as first and second regions I and II, respectively, of the handling substrate 420.

The handling substrate 420 may include a semiconductor material, e.g., silicon or an insulating material, e.g., glass, and each of the first and second bonding layers 410 and 430 may include, e.g., silicon carbonitride, silicon oxide, but example embodiments are not limited thereto.

An upper portion of the first substrate 100 may be removed by, e.g., a grinding process, and thus upper surfaces of the first insulation pattern 110 and the first and second gate insulation layers 150 and 210 may be exposed. During the grinding process, the first insulation pattern 110 may serve as an end point.

As the grinding process is performed, a lower portion of the first substrate 100 may remain, which may be referred to as a semiconductor pattern 102. The semiconductor pattern 102 may be formed between the first etch stop pattern 125 and the first gate insulation layer 150, and may extend in the first direction D1.

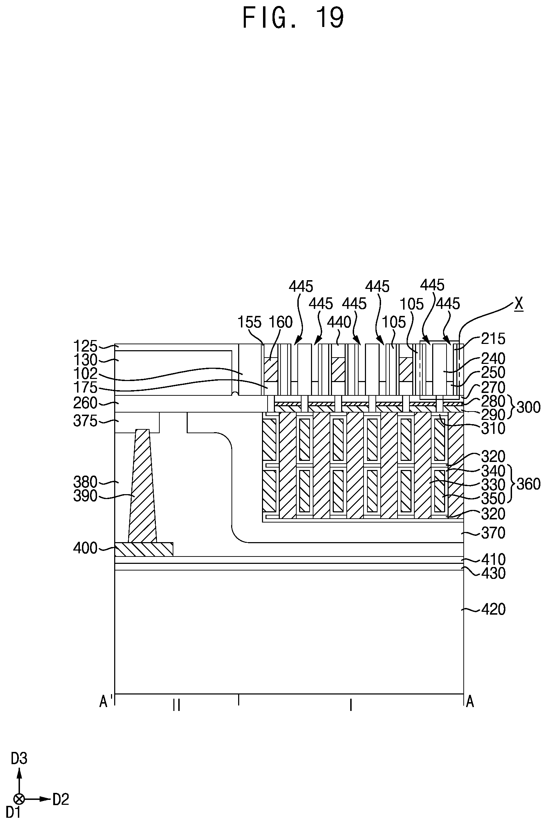

Referring to FIGS. 19 and 20, a planarization process, e.g., a CMP process may be performed to remove the first insulation pattern 110, the third insulation pattern 240, and upper portions of the semiconductor pattern 102, the channel 105, the first and second gate insulation layers 150 and 210, the first gate electrode structure 160, and the second mold layer 20.

In some example embodiments, during the CMP process, the first etch stop pattern 125 may serve as an end point.

As the planarization process is performed, the first and second gate insulation layers 150 and 210, and the second mold 20, each of which may have a cross-section of a "U" shape, may be divided into the first and second gate insulation patterns 155 and 215 and second mold patterns, respectively, each of which may extend in the third direction D3. The first gate electrode structure 160 and the first gate insulation pattern 155 may collectively form a first gate structure.

An upper portion of the first gate electrode structure 160 may be removed to form a third recess, and a third capping patterns 440 may be formed in the third recess.

Thereafter, the second mold pattern is removed to form a fourth opening 445 exposing a sidewall of the third insulation pattern 240, an upper surface of the second capping pattern 250, and a sidewall of the second gate insulation pattern 215. The fourth opening 445 may extend in the first direction D1 along the sidewall of the second gate insulation pattern 215. In some example embodiments, the fourth opening 445 may have a zigzag shape, instead of being formed in a straight line in the first direction D1, corresponding to the second mold layer 20.

In some example embodiments, the second mold layer 20 may be removed by, e.g., a wet etching process using phosphoric acid (H₂PO₃) as an etchant, but example embodiments are not limited thereto.

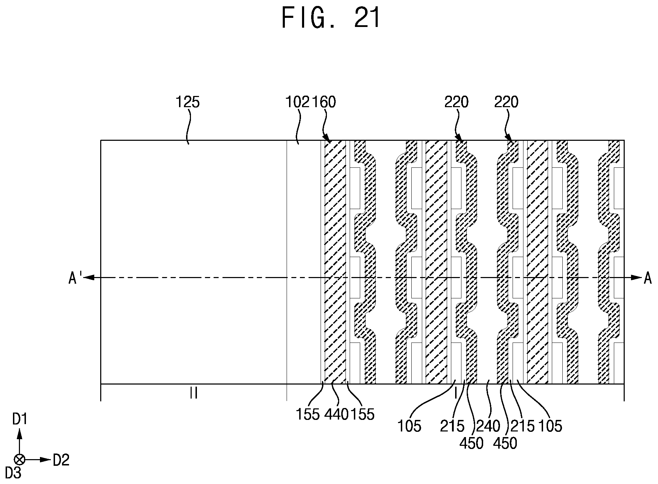

Referring to FIGS. 21 to 23, first and second conductive layers may be sequentially formed on the upper surface of the third insulation pattern 240, a bottom and a sidewall of the fourth opening 445, an uppermost surface of the second gate insulation pattern 215, the upper surface of the channel 105, the uppermost surface of the first gate insulation pattern 155, the upper surface of the third capping pattern 440, the upper surface of the semiconductor pattern 102, and the upper surface of the first etch stop pattern 125.

In some example embodiments, each of the first and second conductive layers may be formed by, e.g., performing an atomic layer deposition (ALD) process, but example embodiments are not limited thereto.

A planarization process, e.g., a chemical mechanical polishing (CMP) process may be performed to remove upper portions of the first and second conductive layers, but example embodiments are not limited thereto. In some example embodiments, during the CMP process, the first etch stop pattern 125 may serve as an end point.

By the planarization process, the second and first conductive layers may be respectively transformed into a fourth conductive pattern 223 and a third conductive pattern 221 that may cover opposite sidewalls and a lower surface of the fourth conductive pattern 223. The third and fourth conductive patterns 221 and 223 may together form a second gate electrode structure 220, and the second gate electrode structure 220 and the second gate insulation pattern 215 may together form a second gate structure.

Two of the second gate structures respectively formed on opposite sidewalls in the second direction D2 of the third insulation pattern 240 may together form a second gate structure pair. A plurality of second gate structure pairs and the first gate structures may be arranged alternately and repeatedly in the second direction D2, and the channel 105 may be formed between the second gate structure pair and the first gate structure that are adjacent to each other in the second direction D2.

An upper portion of the second gate electrode structure 220 may be removed to form a fourth recess, and a fourth capping pattern 450 may be formed in the fourth recess.

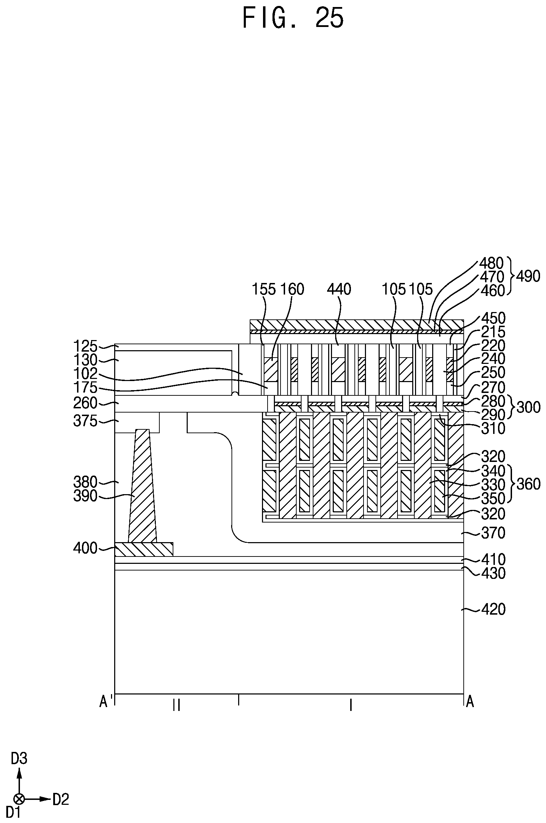

Referring to FIGS. 24 and 25, a bit line structure layer may be formed on the first etch stop pattern 125, the semiconductor pattern 102, the channel 105, the first and second gate electrode structures 160 and 220, the first and second gate insulation patterns 155 and 215, the third insulation pattern 240, and the third and fourth capping patterns 440 and 450, and the bit line structure layer may be patterned to form bit line structures 490, each of which may extend in the second direction D2, and spaced apart from each other in the first direction D1 on the first region I of the handling substrate 420.

In some example embodiments, each of the bit line structures 490 may contact upper surfaces of the channels 105 disposed in the second direction D2, and may also contact upper surfaces of the third and fourth capping patterns 440 and 450, the first and second gate insulation patterns 155 and 215, and the third insulation pattern 240.

In some example embodiments, the bit line structure 490 may include the fifth, sixth and seventh conductive patterns 460, 470 and 480 sequentially stacked in the third direction D3.

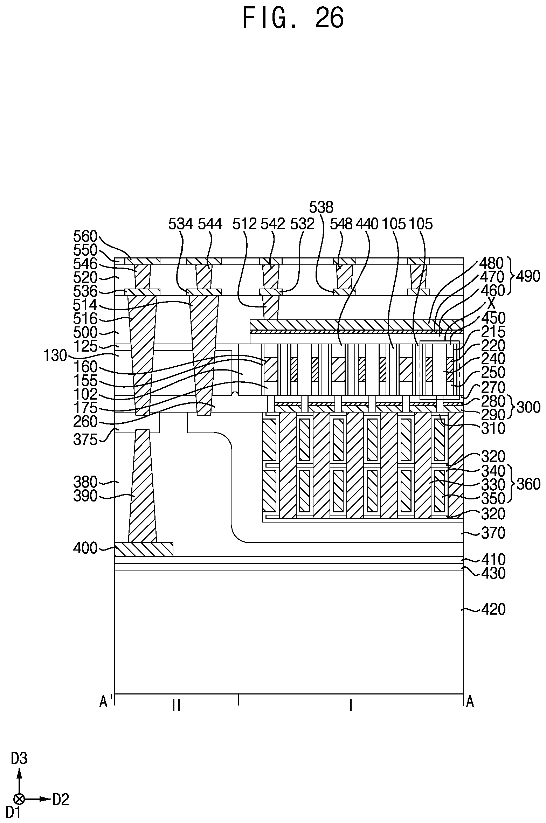

Referring to FIG. 26, a third insulating interlayer 500 may be formed on the first etch stop pattern 125 and the bit line structure 490 The second contact plug 512 extending through the third insulating interlayer 500 to contact an upper surface of the bit line structure 490, the second and third through vias 514 and 516 extending through the third insulating interlayer 500, the first etch stop pattern 125, and the second insulation pattern 130 may be formed to contact respective upper surfaces of the plate electrode 370 and the first conductive pad 375.

First to fourth wirings 532, 534, 536 and 538, and first to fourth vias 542, 544, 546 and 548 may be formed on the third insulating interlayer 500, a fourth insulating interlayer 520 may be formed on the third insulating interlayer 500 to cover the first to fourth wirings 532, 534, 536 and 538 and first to fourth vias 542, 544, 546 and 548, a third bonding layer 550 may be formed on the fourth insulating interlayer 520, and first bonding patterns 560 may be formed through the third bonding layer 550 to contact respective upper surfaces of the first to fourth vias 542, 544, 546 and 548.

Referring to FIGS. 1 and 2 again, a peripheral circuit pattern 650 such as a transistor including, e.g., a third gate structure 630 and source/drain regions 605, a wiring structure 660 including, e.g., contact plugs, wirings, vias, etc., and a fifth insulating interlayer 640 covering the peripheral circuit pattern 650 and the wiring structure 660 may be formed on a second substrate 600, a fourth bonding layer 670 may be formed on the fifth insulating interlayer 640, and second bonding patterns 680 may be formed extending through the fourth bonding layer 670 to contact respective upper surfaces of the vias.

After flipping the handling substrate 420, the third bonding layer 550 may be bonded with the fourth bonding layer 670 on the second substrate 600, and the first bonding patterns 560 may contact corresponding ones of the second bonding patterns 680. The handling substrate 420 and the first and second bonding layers 410 and 430 may be removed from the fifth insulating interlayer 640 by, e.g., a grinding process and/or a CMP process to complete the fabrication of the semiconductor device.

Portions of the second substrate 600 overlapping the first and second regions I and **II,** respectively, of the handling substrate 420 may be referred to as first and second regions I and **II,** respectively, of the second substrate 600.

As illustrated and/or described above, after forming the second mold layer 20 in the third trench 200, which extends through the upper portion of the first substrate 100, the landing pad structure 300 and the capacitor 360 may be formed on the first substrate 100. Thereafter, structures on the first substrate 100 may be turned over using the handling substrate 420, and the second gate electrode structure 220 may be formed within the fourth opening 445 which is formed by removing the second mold layer 20.

If the second gate electrode layer structure is first formed in the third trench 200 and the landing pad structure 300, and the capacitor 360 is formed thereafter, the second gate electrode structure 220 may be damaged by heat accompanying the formation process of the landing pad structure 300 and the capacitor 360.

However, in the method of manufacturing the semiconductor device in accordance with example embodiments, the second gate electrode structure 220 may be formed after forming the landing pad structure 300 and the capacitor 360, and accordingly, the quality of the second gate electrode structure 220 may not be deteriorated.

Additionally, in the case of forming the second gate electrode layer structure in the third trench 200 instead of the second mold layer 20, during the process of forming the third insulation layer 230 to fill the third trench 200 on the second gate electrode layer structure, the second gate electrode layer structure may be partially oxidized, thereby deteriorating electrical characteristics of the second gate electrode structure 220.

However, in the method of manufacturing the semiconductor device in accordance with example embodiments, the third insulation layer 230 may be formed on the second mold layer 20, and the second gate electrode structure 220 may be formed within the fourth opening 445, which is formed by removing the second mold layer 20. Accordingly, the second gate electrode structure 220 may be prevented from being oxidized (or a probability of the second gate electrode structure 220 being oxidized may be reduced).

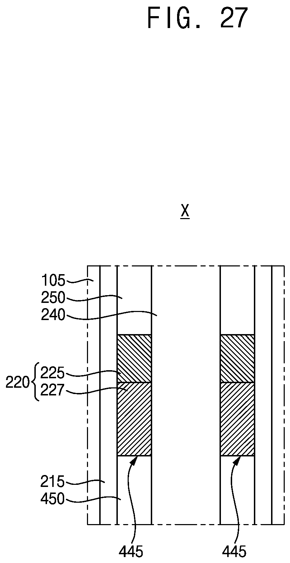

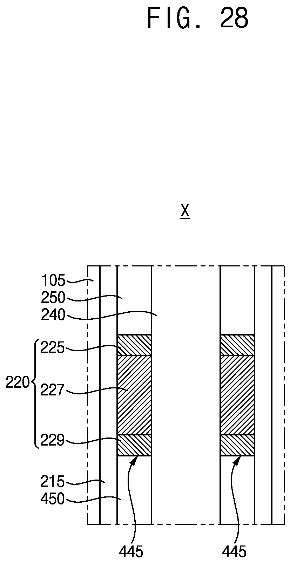

In addition, compared to the case where the second gate electrode layer structure having a "U" shape is formed in the third trench 200, the first substrate 100 is turned over, and the planarization process is performed to separate the second gate electrode layer structure into two second gate electrode structures 220, when the second gate electrode structure 220 is formed within the fourth opening 445 formed by removing the second mold layer 20, the second gate electrode structure 220 may be formed by using various deposition process techniques (e.g., refer to FIGS. 27 and 28).

FIG. 27 is a cross-sectional view illustrating a semiconductor device in accordance with some example embodiments (e.g., which may correspond to FIG. 2).

The semiconductor device may be substantially the same as or similar to that of FIGS. 1 and 2, except for configuration of the second gate electrode structure 220, and thus repeated explanations are omitted herein.

Referring to FIG. 27, the second gate electrode structure 220 may include a ninth conductive pattern 227 and an eighth conductive pattern 225 sequentially stacked on the fourth capping pattern 450. Each of the eighth and ninth conductive patterns 225 and 227 may include a metal, e.g., tungsten, molybdenum, ruthenium, cobalt, titanium, tantalum, etc., a metal silicide, e.g., titanium silicide, tungsten silicide, etc. or a metal nitride, e.g., titanium nitride, tantalum nitride, tungsten nitride, molybdenum nitride, etc., but example embodiments are not limited thereto.

In some example embodiments, the eighth conductive pattern 225, which may be closer to the landing pad structure 300, may have a smaller work function than the ninth conductive pattern 227. Accordingly, gate induced drain leakage (GIDL) may be reduced.

The semiconductor device including the eighth and ninth conductive patterns 225 and 227 may be formed by following processes.

Processes substantially the same as or similar to those illustrated with reference to FIGS. 3 to 20 may be performed.

Thereafter, unlike the processes illustrated with reference to FIGS. 21 to 23, a third conductive layer may be formed on the upper surface of the third insulation pattern 240, the uppermost surface of the second gate insulation pattern 215, the upper surface of the channel 105, the uppermost surface of the first gate insulation pattern 155, the upper surface of the third capping pattern 440, the upper surface of the semiconductor pattern 102, and the upper surface of the first etch stop pattern 125 to fill the fourth opening 445, and an upper portion of the third conductive layer may be removed by, e.g., an etch back process to form the eighth conductive pattern 225 at a lower portion of the fourth opening 445.

A selective deposition process using an upper surface of the eighth conductive pattern 225 as a seed may be performed to form the ninth conductive pattern 227 filling the fourth opening 445. The eighth and ninth conductive patterns 225 and 227 may together form the second gate electrode structure 220.

An upper portion of the ninth conductive pattern 227 may be removed to form the fourth recess, and the fourth capping pattern 450 may be formed within the fourth recess.

Manufacturing of the semiconductor device may be completed by performing the processes substantially the same as or similar to the processes illustrated with reference to FIGS. 24 to 26 and FIGS. 1 and 2.

FIG. 28 is a cross-sectional view illustrating a semiconductor device in accordance with some example embodiments (e.g., which may correspond to FIG. 27).

The semiconductor device may be substantially the same as or similar to that of FIG. 27, and thus repeated explanations are omitted herein.

Referring to FIG. 28, the second gate electrode structure 220 may further include a tenth conductive pattern 229. Accordingly, the second gate electrode structure 220 may include the tenth, ninth and eighth conductive patterns 229, 227 and 225 sequentially stacked on the fourth capping pattern 450.

The tenth conductive pattern 229 may include a metal, e.g., tungsten, molybdenum, ruthenium, cobalt, titanium, tantalum, etc., a metal silicide, e.g., titanium silicide, tungsten silicide, etc., or a metal nitride, e.g., titanium nitride, tantalum nitride, tungsten nitride, molybdenum nitride, etc., but example embodiments are not limited thereto.

In some example embodiments, among the eighth to tenth conductive patterns 225, 227 and 229, the tenth conductive pattern 229, which may be the closest to the landing pad structure 300, may have the smallest work function, and the eighth conductive pattern 225, which may be the farthest from the landing pad structure 300, may have the greatest work function. In some example embodiments, the tenth conductive pattern 229 adjacent to the landing pad structure 300 and the eighth conductive pattern 225 adjacent to the bit line structure 490 have a smaller work function than the ninth conductive pattern 227. Accordingly, GIDL may decrease.

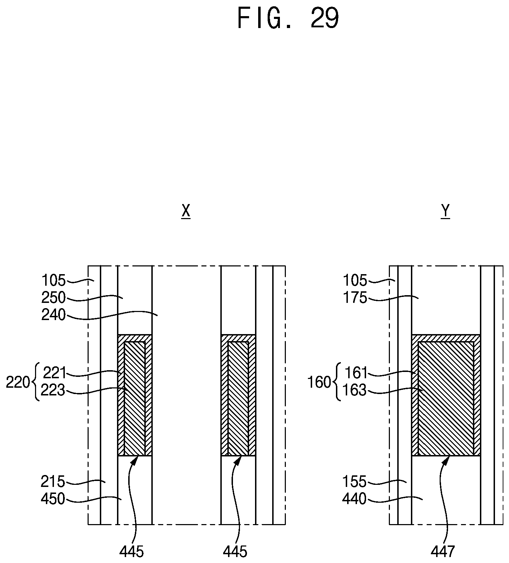

FIG. 29 is a cross-sectional view illustrating a semiconductor device in accordance with some example embodiments (e.g., which may correspond to FIG. 2). Meanwhile, FIG. 29 further includes an enlarged cross-sectional view of region Y illustrating the first gate structure and its surroundings.

The semiconductor device may be substantially the same as or similar to that of FIG. 2 except for configurations of the first and second gate electrode structures 160 and 220, and thus repeated explanations are omitted herein.

Referring to FIG. 29, like the second gate electrode structure 220, including the fourth conductive pattern 223 and the third conductive pattern 221 covering the opposite sidewalls and the upper surface of the fourth conductive pattern 223, the first gate electrode structure 160 may include a twelfth conductive pattern 163 and an eleventh conductive pattern 161 covering opposite sidewalls and an upper surface of the twelfth conductive pattern 163.

In some example embodiments, the third and eleventh conductive patterns 221 and 161 may include substantially the same material, and the fourth and twelfth conductive patterns 223 and 163 may include substantially the same material.

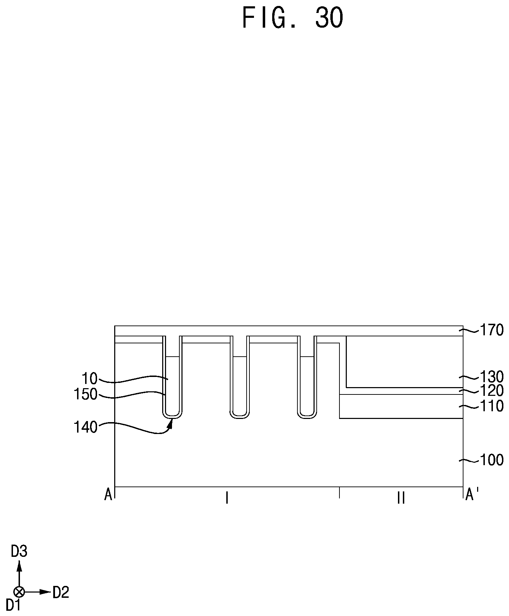

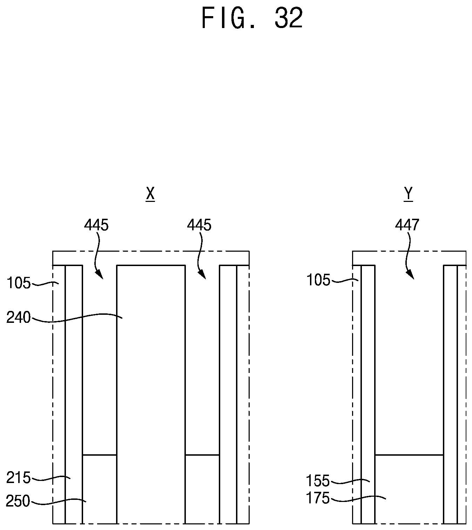

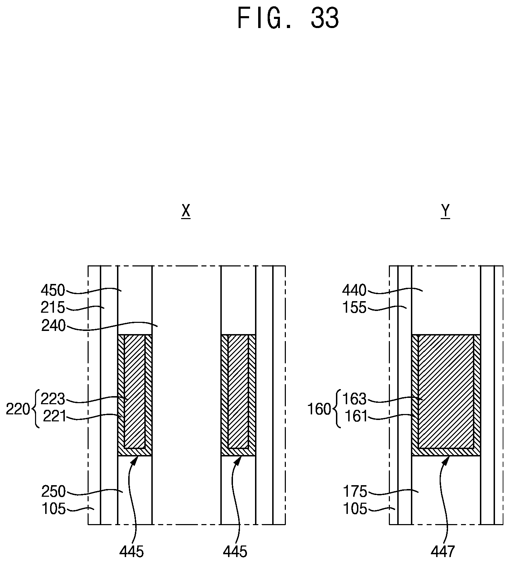

FIGS. 30 to 33 are cross-sectional views illustrating a method of manufacturing a semiconductor device in accordance with some example embodiments. FIGS. 32 and 33 include enlarged cross-sectional views of region X and region Y of corresponding cross-sectional views.

This method may include processes substantially the same as, or similar to, those illustrated with respect to FIGS. 3 to 26 and FIGS. 1 and 2, and thus repeated explanations are omitted herein.

Referring to FIG. 30, processes substantially the same as, or similar to, those illustrated with reference to FIGS. 3 to 5 may be performed.

Thereafter, unlike the processes illustrated with reference to FIG. 5, instead of forming the first gate electrode structure 160 on the first gate insulation layer 150, a first mold layer 10 may be formed on the first gate insulation layer 150 to fill a lower portion of the second trench 140. The first mold layer 10 may include an insulating nitride, e.g., silicon nitride, but example embodiments are not limited thereto.

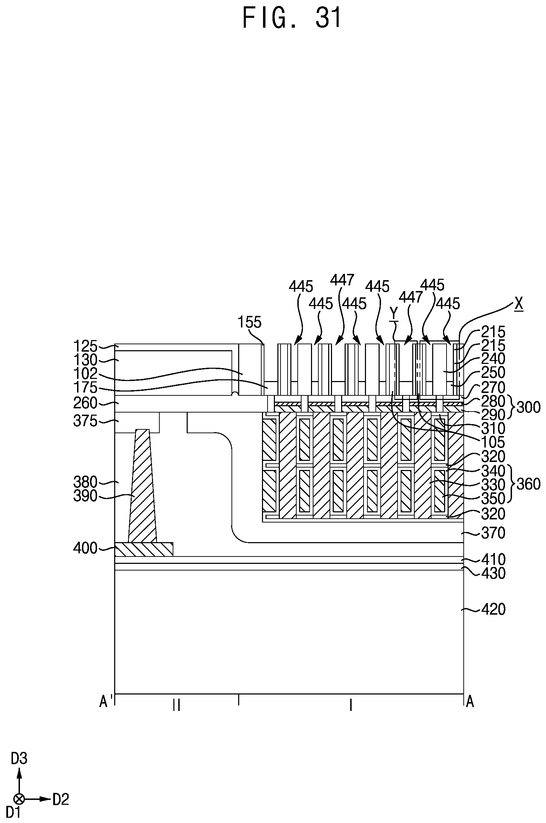

Referring to FIGS. 31 and 32, processes substantially the same as, or similar to, those illustrated with reference to FIGS. 6 to 20 may be performed.

However, unlike the processes illustrated with reference to FIGS. 19 and 20, the second and first mold layers 20 and 10 may be removed to form the fourth opening 445 and a fifth opening 447, respectively. The fifth opening 447 may be formed to expose a sidewall of the first gate insulation pattern 155 and an upper surface of the first capping pattern 175, and the fifth opening 447 may be formed to extend in the first direction D1 along the sidewall of the first gate insulation pattern 155.

Referring to FIG. 33, processes substantially the same as, or similar to, those illustrated with reference to FIGS. 21 to 23 may be performed.

However, unlike the processes illustrated with reference to FIGS. 21 to 23, first and second conductive layers may be sequentially formed on the upper surface of the third insulation pattern 240, the bottom and the sidewall of the fourth opening 445, the uppermost surface of the second gate insulation pattern 215, the upper surface of the channel 105, a bottom and a sidewall of the fifth opening 447, the uppermost surface of the first gate insulation pattern 155, the upper surface of the semiconductor pattern 102, and the upper surface of the first etch stop pattern 125. Thereafter, upper portions of the first and second conductive layers may be removed by performing a planarization process, e.g., a chemical mechanical polishing (CMP) process, but example embodiments are not limited thereto.

By the planarization process, the second and first conductive layers within the fourth opening 445 may be respectively transformed into the fourth conductive pattern 223 and the third conductive pattern 221 covering the opposite sidewalls and the lower surface of the fourth conductive pattern 223, and the second and first conductive layers within the fifth opening 447 may be respectively transformed into a twelfth conductive pattern 163 and an eleventh conductive pattern 161 covering opposite sidewalls and a lower surface of the twelfth conductive pattern 163. The third and fourth conductive patterns 221 and 223 may together form the second gate electrode structure 220, and the eleventh and twelfth conductive patterns 161 and 163 may together form the first gate electrode structure 160.

Thereafter, manufacturing of the semiconductor device may be completed by performing processes substantially the same as, or similar to, those illustrated with reference to FIGS. 24 to 26 and FIGS. 1 and 2.

In the method of manufacturing a semiconductor device in accordance with some example embodiments, the first and second gate electrode structures 160 and 220 may be formed simultaneously. Accordingly, cost may reduce.

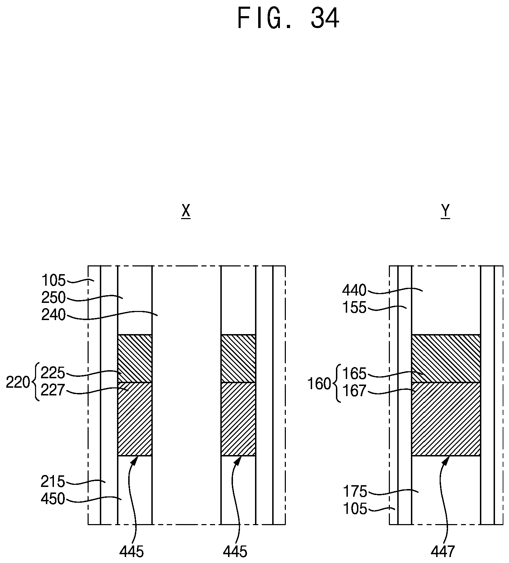

FIG. 34 is a cross-sectional view illustrating a semiconductor device in accordance with some example embodiments (e.g., which may correspond to FIG. 29).

The semiconductor device may be substantially the same as, or similar to, that of FIG. 29 except for configurations of the first and second gate electrode structures 160 and 220, and thus repeated explanations are omitted herein.

Referring to FIG. 34, similar to the second gate electrode structure 220 illustrated with reference to FIG. 27, the second gate electrode structure 220 may include the ninth and eighth conductive patterns 227 and 225 sequentially stacked on the fourth capping pattern 450.

Likewise to the second gate electrode structure 220 including the ninth and eighth conductive patterns 227 and 225 sequentially stacked on the fourth capping pattern 450, the first gate electrode structure 160 may include a fourteenth conductive pattern 167 and a thirteenth conductive pattern 165 sequentially stacked on the third capping pattern 440.

In some example embodiments, the eighth and thirteenth conductive patterns 225 and 165 may include substantially the same material, and the ninth and fourteenth conductive patterns 227 and 167 may include substantially the same material.

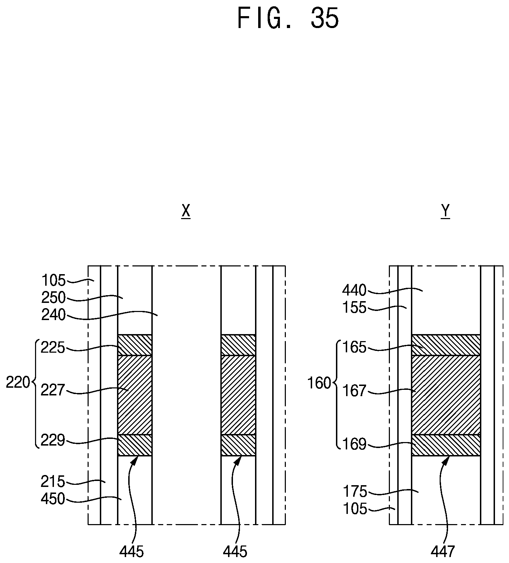

FIG. 35 is a cross-sectional view illustrating a semiconductor device in accordance with some example embodiments (e.g., which may correspond to FIG. 34).

The semiconductor device may be substantially the same as, or similar to, that of FIG. 34 except for configurations of the first and second gate electrode structures 160 and 220, and thus repeated explanations are omitted herein.

Referring to FIG. 35, similar to the second gate electrode structure 220 illustrated with reference to FIG. 28, the second gate electrode structure 220 may further include a tenth conductive pattern 229. Accordingly, the second gate electrode structure 220 may include the tenth, ninth, and eighth conductive patterns 229, 227 and 225 sequentially stacked on the fourth capping pattern 450.

Similar to the second gate electrode structure 220 including the tenth, ninth, and eighth conductive patterns 229, 227 and 225 sequentially stacked on the fourth capping pattern 450, the first gate electrode structure 160 may include a fifteenth conductive pattern 169, the fourteenth conductive pattern 167, and the thirteenth conductive pattern 165 sequentially stacked on the third capping pattern 440.

In some example embodiments, the tenth and fifteenth conductive patterns 229 and 169 may include substantially the same material.

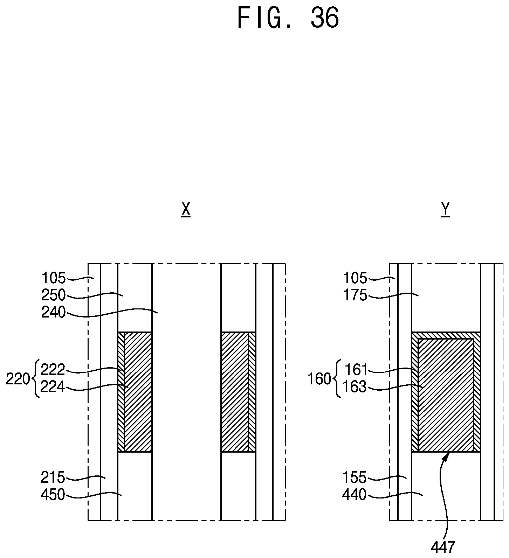

FIG. 36 is a cross-sectional view illustrating a semiconductor device in accordance with some example embodiments (e.g., which may correspond to FIG. 2). Meanwhile, FIG. 36 further includes an enlarged cross-sectional view of region Y illustrating the first gate structure and its surroundings.

The semiconductor device may be substantially the same as, or similar to, that of FIG. 2 except for configurations of the first and second gate electrode structures 160 and 220, and thus repeated explanations are omitted herein.

Referring to FIG. 36, the second gate electrode structure 220 may include a seventeenth conductive pattern 224 and a sixteenth conductive pattern 222 sequentially stacked in the horizontal direction at a sidewall of the third insulation pattern 240. In other words, in a cross-sectional view taken along a plane defined by the second and third directions D2 and D3, the seventeenth conductive pattern 224 may extend in the third direction D3 along the sidewall of the third insulation pattern 240 to contact the upper surface of the fourth capping pattern 450 and the lower surface of the second capping pattern 250, and the sixteenth conductive pattern 222 may extend in the third direction D3 along a sidewall of the seventeenth conductive pattern 224 to contact the upper surface of the fourth capping pattern 450 and the lower surface of the second capping pattern 250 .

At a cross-section taken along a plane defined by the second and third directions D2 and D3, the second gate electrode structures 220 of the second gate structure pair may be substantially symmetrical about a center line that passes through a geometric center of the third insulation pattern 240 and extends in the third direction D3.

The first gate electrode structure 160 may be substantially the same as, or similar, to the first gate electrode structure 160 of the semiconductor device illustrated with reference to FIG. 29.

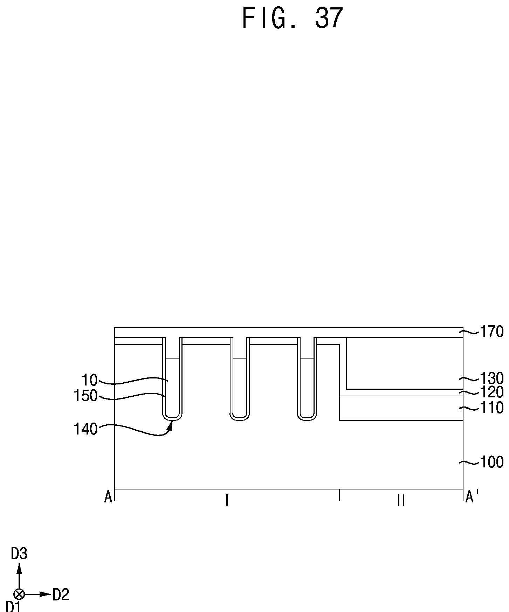

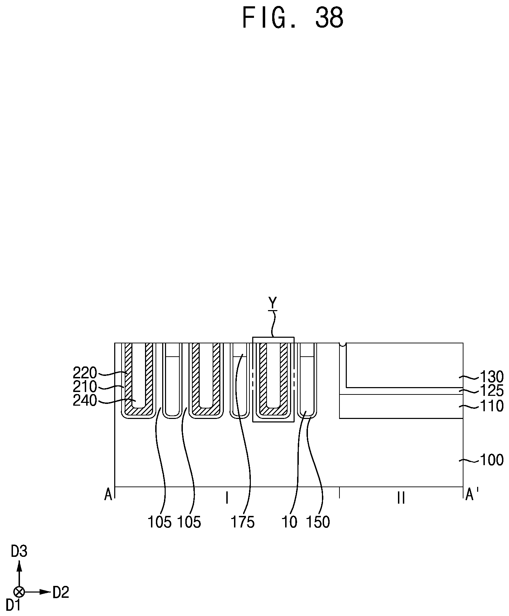

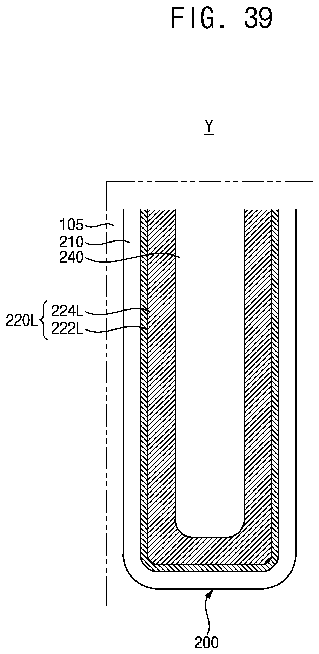

FIGS. 37 to 40 are cross-sectional views illustrating a method of manufacturing a semiconductor device in accordance with some example embodiments. FIG. 39 is an enlarged cross-sectional view of region Y of the corresponding cross-sectional view of FIG. 38.

This method may include processes substantially the same as, or similar to, those illustrated with respect to FIGS. 3 to 26 and FIGS. 1 and 2, and thus repeated explanations are omitted herein.

Referring to FIG. 37, processes substantially the same as, or similar to, those illustrated with reference to FIGS. 3 to 5 may be performed.

However, unlike the processes illustrated with reference to FIG. 5, instead of forming the first gate electrode structure 160 on the first gate insulation layer 150, a first mold layer 10 may be formed on the first gate insulation layer 150 to fill the second trench 140. The first mold layer 10 may include an insulating nitride, e.g., silicon nitride, but example embodiments are not limited thereto.

Referring to FIGS. 38 and 39, processes substantially the same as, or similar to, those illustrated with reference to FIGS. 6 to 10 may be performed. However, unlike the processes illustrated with reference to FIG. 10, instead of the second mold layer 20, the second gate insulation layer 210 and the second gate electrode layer structure 220L may be sequentially stacked on the inner wall of the third trench 200, the surface of the spacer 185, the uppermost surface of the first gate insulation layer 150, the upper surface of the first capping pattern 175, the upper surface and the sidewall of the preliminary spacer 180, the upper surface of the portion of the first region I of the first substrate 100 adjacent to the second region II thereof, the uppermost surface of the first etch stop pattern 125 and the upper surface of the second insulation pattern 130.

The second gate electrode layer structure 220L may include a fourth conductive layer 222L and a fifth conductive layer 224L sequentially stacked. The fourth conductive layer 222L may include a metal nitride, e.g., titanium nitride, tantalum nitride, tungsten nitride, molybdenum nitride, etc., and the fifth conductive layer 224L may include a metal, e.g., tungsten, molybdenum, ruthenium, cobalt, titanium, tantalum, etc., or a metal silicide, e.g., titanium silicide, tungsten silicide, etc., but example embodiments are not limited thereto.

Thereafter, processes substantially the same as, or similar to, those illustrated with reference to FIGS. 11 and 12 may be performed. A cross-section of each of the second gate insulation layer 210 and the second gate electrode layer structure 220L taken along a plane defined by the second and third directions D2 and D3 may be formed to have a "U" shape.

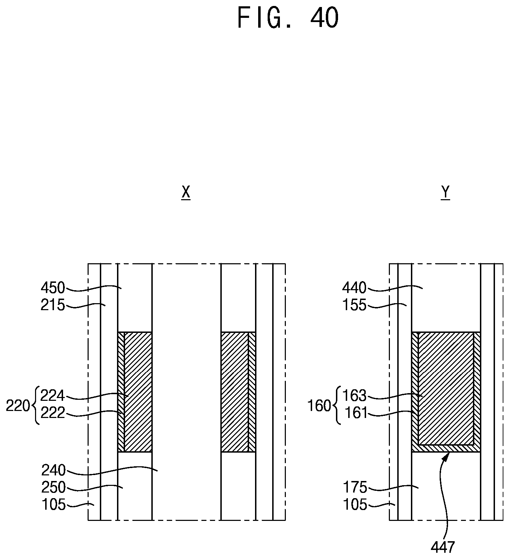

Referring to FIG. 40, processes substantially the same as, or similar to, those illustrated with reference to FIGS. 13 to 23 may be performed.

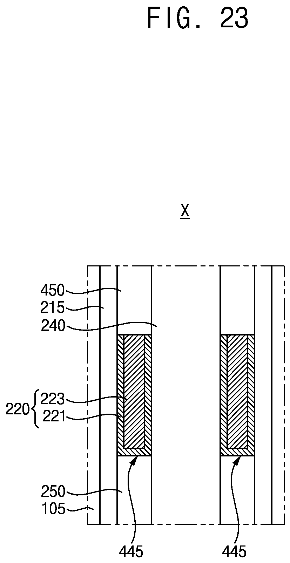

However, unlike the processes illustrated with reference to FIGS. 19 and 23, a planarization process, e.g., a chemical mechanical polishing (CMP) process may be performed to remove upper portions of the first insulation pattern 110, the third insulation pattern 240, the semiconductor pattern 102, the channel 105, the first and second gate insulation layers 150 and 210, the first mold layer 10, and the second gate electrode layer structure 220L.

By the planarization process, the first and second gate insulation layers 150 and 210 and the second gate electrode layer structure 220L each having a "U" shaped cross-section taken along a plane defined by the second and third directions D2 and D3 may be respectively divided into the first and second gate insulation patterns 155 and 215, and the second gate electrode structure 220. The second gate electrode structure 220 may include a seventeenth conductive pattern 224 and a sixteenth conductive pattern 222 sequentially stacked at a sidewall of the third insulation pattern 240.

Thereafter, the upper portion of the second gate electrode structure 220 may be removed to form the fourth recess, and the fourth capping pattern 450 may be formed within the fourth recess.

The first mold layer 10 may be removed to form the fifth opening 447 exposing the sidewall of the first gate insulation pattern 155 and the upper surface of the first capping pattern 175. The fifth opening 447 may extend in the first direction D1 along the sidewall of the first gate insulation pattern 155.

In some example embodiments, the first mold layer 10 may be removed by, e.g. a wet etching process using phosphoric acid (H₂PO₃) as an etchant, which may remove the first mold layer 10 with a high etch selectivity.

Thereafter, sixth and seventh conductive layers may be sequentially formed on the bottom and the sidewall of the fifth opening 447, the uppermost surface of the first gate insulation pattern 155, the upper surface of the channel 105, the uppermost surface of the second gate insulation pattern 215, the upper surface of the fourth capping pattern 450, the upper surface of the semiconductor pattern 102, and the upper surface of the first etch stop pattern 125.

A planarization process, e.g., a chemical mechanical polishing (CMP) process may be performed. Accordingly, the seventh and sixth conductive layers may be respectively transformed into a twelfth conductive pattern 163 and an eleventh conductive pattern 161 covering opposite sidewalls and a lower surface of the twelfth conductive pattern 163. The eleventh and twelfth conductive patterns 161 and 163 may together form the first gate electrode structure 160.

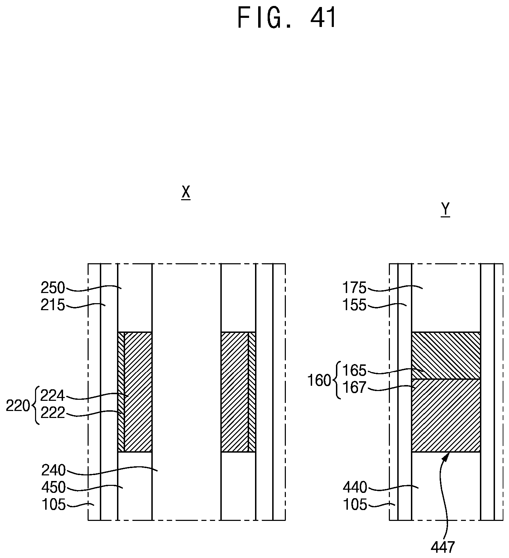

FIG. 41 is a cross-sectional view illustrating a semiconductor device in accordance with some example embodiments, which may correspond to FIG. 36.

The semiconductor device may be substantially the same as, or similar to, that of FIG. 36 except for configuration of the first gate electrode structure 160, and thus repeated explanations are omitted herein.

Referring to FIG. 41, similar to the semiconductor device illustrated with reference to FIG. 34, the first gate electrode structure 160 may include the fourteenth and thirteenth conductive patterns 167 and 165 sequentially stacked on the third capping pattern 440.

Each of the thirteenth and fourteenth conductive patterns 165 and 167 may include a metal, e.g., tungsten, molybdenum, ruthenium, cobalt, titanium, tantalum, etc., a metal silicide, e.g., titanium silicide, tungsten silicide, etc., or a metal nitride, e.g., titanium nitride, tantalum nitride, tungsten nitride, molybdenum nitride, etc., but example embodiments are not limited thereto.

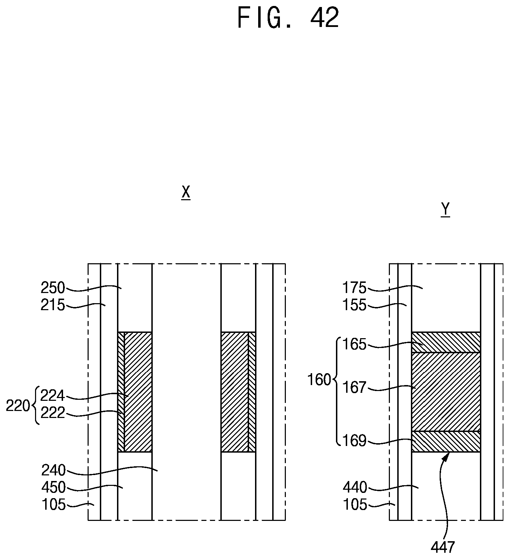

FIG. 42 is a cross-sectional view illustrating a semiconductor device in accordance with some example embodiments, which may correspond to FIG. 36.

The semiconductor device may be substantially the same as, or similar to, that of FIG. 36 except for configuration of the first gate electrode structure 160, and thus repeated explanations are omitted herein.

Referring to FIG. 42, similar to the semiconductor device illustrated with reference to FIG. 35, the first gate electrode structure 160 may include the fifteenth, fourteenth, and thirteenth conductive patterns structures 169, 167 and 165 sequentially stacked on the third capping pattern 440.

The fifteenth conductive pattern 169 may include a metal, e.g., tungsten, molybdenum, ruthenium, cobalt, titanium, tantalum, etc., a metal silicide, e.g., titanium silicide, tungsten silicide, etc., or a metal nitride, e.g., titanium nitride, tantalum nitride, tungsten nitride, molybdenum nitride, etc., but example embodiments are not limited thereto.

The foregoing is illustrative of some example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concepts as defined in the claims. In the claims, if applicable, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
a bit line structure (490) on a substrate (600) and extending in a first direction (D2) parallel to an upper surface of the substrate (600);
a channel (105) on and electrically connected to the bit line structure (490);
a front-gate electrode structure (220) at a side of the channel (105) in the first direction (D2), the front-gate electrode structure (220) including a first conductive pattern (223) and a second conductive pattern (221), the second conductive pattern (221) covering opposite sidewalls and an upper surface of the first conductive pattern (223); and
a capacitor (360) on and electrically connected to the channel (105).

2. The semiconductor device according to claim 1, further comprising a back-gate electrode structure (160) at another side of the channel (105) in the first direction (D2).

3. The semiconductor device according to claim 2, wherein the back-gate electrode structure (160) includes a third conductive pattern (163) and a fourth conductive pattern (161), the fourth conductive pattern (161) covering opposite sidewalls and an upper surface of the third conductive pattern (163).

4. The semiconductor device according to claim 3, wherein the first conductive pattern (223) and the third conductive pattern (163) include the same material, and the second conductive pattern (221) and the fourth conductive pattern (161) include the same material.

5. The semiconductor device according to any one of claims 2 to 4, wherein
a plurality of channels (105) are on the bit line structure (490) and spaced apart from each other in the first direction (D2),
a plurality of front-gate electrode structures (220) including the front-gate electrode structure (220) are respectively at sides of the plurality of channels (105) in the first direction (D2), the plurality of front-gate electrode structures (220) spaced apart from each other in the first direction (D2), and
a plurality of back-gate electrode structures (160) including the back-gate electrode structure (160) are respectively at the other sides of the plurality of channels (105) in the first direction (D2), the plurality of back-gate electrode structures (160) spaced apart from each other in the first direction (D2).

6. The semiconductor device according to claim 5, wherein a front-gate electrode pair, including two of the front-gate electrode structures (220) adjacent to each other in the first direction (D2), is alternately and repeatedly arranged with the back-gate electrode structure (160) along the first direction (D2), and each channel (105) of the plurality of channels (105) is between the front-gate electrode pair and the back-gate electrode structure (160) and adjacent to each other in the first direction (D2).

7. A semiconductor device comprising:
a bit line structure (490) on a substrate (600) and extending in a first direction (D2) parallel to an upper surface of the substrate (600);
a channel (105) on and electrically connected to the bit line structure (490);
a front-gate electrode structure (220) and a front-gate insulation pattern (215), the front-gate electrode structure (220) and the front-gate insulation pattern (215) sequentially stacked at a side of the channel (105) in the first direction (D2);
a capacitor (360) on and electrically connected to the channel (105), and
wherein the front-gate electrode structure (220) includes a first conductive pattern (227) and a second conductive pattern (225) sequentially stacked on the bit line structure (490) in a vertical direction (D3) perpendicular to the upper surface of the substrate (600), and
wherein the front-gate insulation pattern (215) contacts a sidewall of each of the first conductive pattern (227) and the second conductive pattern (225) in the first direction (D2).

8. The semiconductor device according to claim 7, wherein the front-gate electrode structure (220) further includes a third conductive pattern (229), and the front-gate insulation pattern (215) contacts a sidewall of the third conductive pattern (229) in the first direction (D2).

9. The semiconductor device according to claim 7, further comprising a back-gate electrode structure (160) at another side of the channel (105) in the first direction (D2).

10. The semiconductor device according to claim 9, wherein the back-gate electrode structure (160) includes a third conductive pattern (167) and a fourth conductive pattern (165) sequentially stacked on the bit line structure (490) in the vertical direction (D3).

11. The semiconductor device according to claim 10, wherein the first conductive pattern (227) and the third conductive pattern (167) include the same material, and the second conductive pattern (225) and the fourth conductive pattern (165) include the same material.

12. The semiconductor device according to claim 10 or 11, wherein the front-gate electrode structure (220) further includes a third conductive pattern (229) on the first conductive pattern (227), and the back-gate electrode structure (160) further includes a sixth conductive pattern (169) on the fourth conductive pattern (167), the third conductive pattern (229) and the sixth conductive pattern (169) include the same material, and the front-gate insulation pattern (220) contacts a sidewall of the third conductive pattern (229) in the first direction (D2).

13. The semiconductor device according to claim 9, wherein
a plurality of channels (105) are on the bit line structure (490) and spaced apart from each other in the first direction (D2),
a plurality of front-gate electrode structures (220) including the front-gate electrode structure (220) are respectively at sides of the plurality of channels (105) in the first direction (D2), the plurality of front-gate electrode structures (220) spaced apart from each other in the first direction (D2), and
a plurality of back-gate electrode structures (160) including the back-gate electrode structure (160) are respectively at the other sides of the plurality of channels (105) in the first direction (D2), the plurality of back-gate electrode structures (160) spaced apart from each other in the first direction (D2).

14. The semiconductor device according to claim 13, wherein a front-gate electrode pair, including two of the front-gate electrode structures (220) adjacent to each other in the first direction (D2), is alternately and repeatedly arranged with the back-gate electrode structure (160) along the first direction (D2), and each channel (105) of the plurality of channels (105) is between the front-gate electrode pair and the back-gate electrode structure (160) adjacent to each other in the first direction (D2).

15. A semiconductor device comprising:
a bit line structure (490) on a substrate (600), the bit line structure (490) extending in a first direction (D2) parallel to an upper surface of the substrate (600);
a channel (105) on and electrically connected to the bit line structure (490);
a front-gate electrode structure (220) at a side of the channel (105) in the first direction (D2), the front-gate electrode structure (220) including a first conductive pattern (221; 227) and a second conductive pattern (223; 225) sequentially stacked on the bit line structure (490) in a vertical direction (D3) perpendicular to the upper surface of the substrate (600);
a back-gate electrode structure (160) at another side of the channel (105) in the first direction (D2); and
a capacitor (360) on and electrically connected to the channel (105), and
wherein a cross-section of each of the first conductive pattern (221; 227) and the second conductive pattern (223; 225) taken along a plane defined by the first direction (D2) and the vertical direction (D3) is symmetrical about a center line that extends in the vertical direction (D3) and passes through a geometric center of the front-gate electrode structure (220).
